# EUROPEAN PATENT APPLICATION

(11) **EP 4 376 560 A1**
(43) Date of publication of application: **29.05.2024**
(21) Application number: 22861587.8
(22) Date of filing: 05.08.2022
(51) Int. Cl.: H05K 1/11, H05K 1/02, H04M 1/02, H05K 3/46

(54) **INTERPOSER AND ELECTRONIC DEVICE COMPRISING SAME**

(30) Priority: 26.08.2021 KR 20210113264; 18.10.2021 KR 20210138528
(71) Applicant: Samsung Electronics Co., Ltd., Suwon-si, Gyeonggi-do 16677 (KR)
(72) Inventor: JO, Youngsun, Suwon-si Gyeonggi-do 16677 (KR); KIM, Dohoon, Suwon-si Gyeonggi-do 16677 (KR); KIM, Sangyong, Suwon-si Gyeonggi-do 16677 (KR); MIN, Bongkyu, Suwon-si Gyeonggi-do 16677 (KR); PARK, Seoyoung, Suwon-si Gyeonggi-do 16677 (KR); CHI, Yunoh, Suwon-si Gyeonggi-do 16677 (KR)
(74) Representative: Gulde & Partner
(86) International application number: PCT/KR2022/011599
(87) International publication number: WO 2023/027376

(57) **Abstract**

An electronic device is disclosed. The electronic device comprises: a housing; a first board and a second board which are disposed within the housing; and an interposer which electrically connects the first board and the second board to each other. The interposer includes a first part forming the outer surface thereof and a second part forming the inner surface thereof. Vias included in the first part may be all a ground via and may be spaced a first interval apart from each other, and vias included in the second part may comprise signal vias and ground vias fewer than the signal vias and may be spaced a second interval greater than or equal to the first interval apart from each other.

## Description

### [Technical Field]

Embodiments disclosed in the disclosure relate to an interposer and an electronic device including the same.

### [Background Art]

As functions equipped in an electronic device become more various, clock frequencies of electronic elements become higher and data transmission speed becomes higher. Due to the electric elements that are operated at high frequencies, electromagnetic interferences (EMIs) may occur or a problem due to an electrostatic discharge (ESD) may occur. This may cause an operation error of the electronic device. Furthermore, an RF immunity problem may be caused.

The electronic device may include two or more boards, on which the electric elements are mounted. The two or more boards may be disposed to overlap each other. The electronic device may include an interposer for electrically connecting the two or more boards. The interposer may be configured to surround facing areas of two boards. The interposer may electrically connect included circuits, and may shield areas surrounded by the interposer.

### [Disclosure]

### [Technical Problem]

Embodiments disclosed in the disclosure provide an interposer that improves a shielding performance by utilizing some vias while not including a separate side plating area, and an electronic device including the same.

### [Technical Solution]

An electronic device according to embodiment disclosed in the disclosure includes a housing, a first board and a second board disposed in an interior of the housing and disposed to face each other in a first direction, and an interposer extending to surround an interior space between the first board and the second board, electrically connecting the first board and the second board, and including vias extending in the first direction, wherein the interposer includes a first part defining an outer surface thereof, and a second part defining an inner surface thereof, which faces the interior space, and surrounded by the first part, and wherein the first part shields the second part and the interior space, the vias included in the first part may be all ground vias and are spaced apart from each other by a first distance, and the vias included in the second part may include signal vias and ground vias, the number of which is smaller than that of the signal vias, and are spaced apart from each other by a second distance that is larger than or equal to the first distance.

### [Advantageous Effects]

Because the interposer according to embodiments disclosed in the disclosure may be manufactured without any separate plating process, production costs may be reduced. Furthermore, because the interposer includes a fence structure including vias, an improved shielding performance may be provided. In addition, the disclosure may provide various effects that are directly or indirectly recognized.

### [Description of Drawings]

FIG. 1 is a perspective view of a front surface of an electronic device according to an embodiment.
FIG. 2 is a perspective view of a rear surface of an electronic device according to an embodiment.
FIG. 3 is an exploded perspective view of an electronic device according to an embodiment.
FIG. 4 is a view illustrating an electronic device according to an embodiment.
FIG. 5 is a view illustrating an interposer of an electronic device according to an embodiment.
FIG. 6 is a plan view of an interposer according to an embodiment.
FIG. 7A is a cross-sectional view of an interposer according to an embodiment.
FIG. 7B is a cross-sectional view of an interposer according to an embodiment.
FIG. 8 is a plan view of an interposer according to an embodiment.
FIG. 9A is a cross-sectional view of a second structure of an interposer according to an embodiment.
FIG. 9B is a cross-sectional view of a third structure of an interposer according to an embodiment.
FIG. 10 is a plan view of an interposer according to an embodiment.
FIG. 11A is a cross-sectional view of a first part of an interposer according to an embodiment.
FIG. 11B is a cross-sectional view of a first part of an interposer according to an embodiment.
FIG. 12A is a view illustrating a portion of a surface of a first part of an interposer according to various embodiments.
FIG. 12B is a view illustrating a portion of a surface of a first part of an interposer according to various embodiments.
FIG. 13A is a view illustrating a portion of a surface of a first part of an interposer according to various embodiments.
FIG. 13B is a view illustrating a portion of a surface of a first part of an interposer according to various embodiments.
FIG. 13C is a view illustrating a portion of a surface of a first part of an interposer according to various embodiments.
FIG. 14A is a view illustrating a portion of a surface of a first part of an interposer according to various embodiments.
FIG. 14B is a view illustrating a portion of a surface of a first part of an interposer according to various embodiments.
FIG. 15 is a view illustrating an interposer according to various embodiments.
FIGS. 16A, 16B, and 16C are views illustrating disposition of ground vias according to various embodiments.
FIG. 17 is a block diagram of an electronic device in a network environment according to various embodiments.

With regard to description of drawings, the same or similar components may be marked by the same or similar reference numerals.

### [Mode for Invention]

Hereinafter, various embodiments of the disclosure will be described with reference to the accompanying drawings. Accordingly, those of ordinary skill in the art will recognize that modification, equivalent, and/or alternative on the various embodiments described herein can be variously made without departing from the scope and spirit of the disclosure.

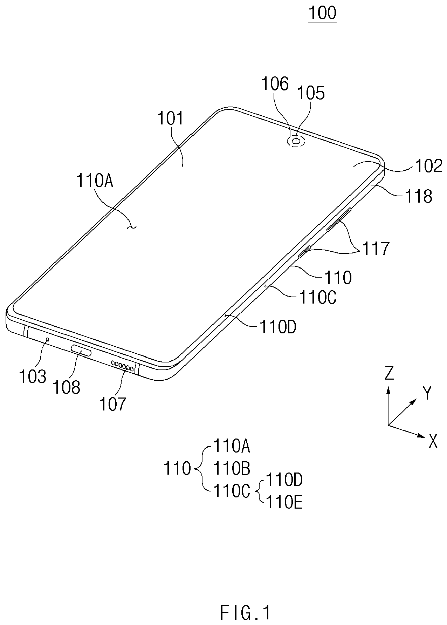

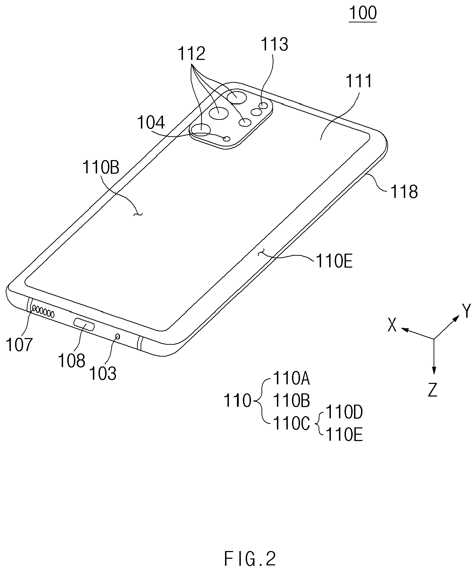

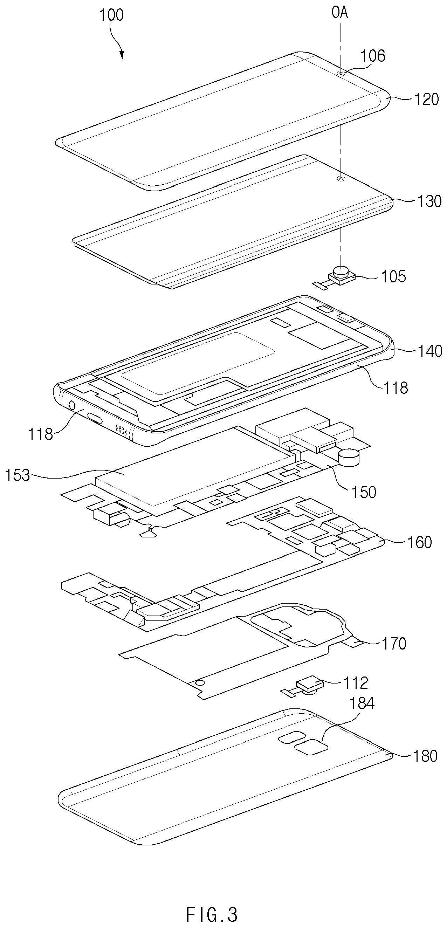

FIG. 1 is a front perspective view of an electronic device 100 according to an embodiment. FIG. 2 is a rear perspective view of the electronic device 100 according to an embodiment. FIG. 3 is an exploded perspective view of the electronic device 100 according to an embodiment.

Referring to FIGS. 1 and 2, the electronic device 100 may include a housing 110 including a first surface (or a front surface) 110A, a second surface (or a rear surface) 110B, and a side surface 110C that surrounds a space between the first surface 110A and the second surface 110B.

In another embodiment (not illustrated), the housing 110 may refer to a structure that defines some of the first surface 110A, the second surface 110B, and the side surface 110C.

According to an embodiment, the first surface 110A may be defined by a front plate 102 (e.g., a front plate 120 of FIG. 3), at least a portion of which is substantially transparent. In an embodiment, the front plate 102, for example, may include a glass plate or a polymer plate including various coating layers. According to an embodiment, the second surface 110B may be defined by a rear plate 111 (e.g., a rear plate 180 of FIG. 3), which is substantially opaque. The rear plate 111, for example, may be formed of coated or colored glass, ceramics, a polymer, a metal (e.g., aluminum, stainless steel (STS), or magnesium), or a combination of at least two thereof. The side surface 110C may be coupled to the front plate 102 and the rear plate 111. The side surface 110C may be defined by a side bezel structure 118 including a metal and/or a polymer.

In another embodiment, the rear plate 111 and the side bezel structure 118 may be integrally formed. The rear plate 111 and the side bezel structure 118 may include the same material (e.g., a metallic material such as aluminum), but the disclosure is not limited thereto.

In the illustrated embodiment, the front plate 102 may include two first areas 110D that are deflected from a partial area of the first surface 110A toward the rear plate 111 and extend seamlessly. The first areas 110D may be located at opposite ends of a long edge of the front plate 102.

In the illustrated embodiment, the rear plate 111 may include two second areas 110E that are deflected from a partial area of the second surface 110B toward the front plate 102 and extend seamlessly. The second areas 110E may be included at opposite ends of a long edge of the rear plate 111.

In another embodiment, the front plate 102 (or the rear plate 111) may include only one of the first areas 110D (or the second areas 110E). Furthermore, in another embodiment, the front plate 102 (or the rear plate 111) may not include some of the first areas 110D (or the second areas 110E).

In an embodiment, when viewed from a side of the electronic device 100, the side bezel structure 118 may have a first thickness (width) on a lateral side (e.g., a short edge), on which neither the first areas 110D nor the second areas 110E are included, and may have a second thickness that is smaller than the first thickness on a lateral side (e.g., a long edge), on which the first areas 110D or the second areas 110E are included.

In an embodiment, the electronic device 100 may include at least one of a display 101, audio modules 103, 104, and 107, a sensor module (not illustrated), camera modules 105 and 112, a key input device 117, a light emitting element (not illustrated), and a connector hole 108. In another embodiment, at least one (e.g., the key input device 117 or the light emitting element (not illustrated)) of the elements may be omitted from the electronic device 100 or another component may be additionally included in the electronic device 100.

In an embodiment, the display 101 may be exposed through at least a portion of the front plate 102. For example, at least a portion of the display 101 may be exposed through the front plate 102 that defines the first surface 110A, and the first areas 110D of the side surface 110C.

In an embodiment, a shape of the display 101 may have a shape that is substantially the same as the adjacent outer shape of the front plate 102. In other embodiments (not illustrated), in order to expand the area, by which the display 101 is exposed, the distances between the outskirts of the display 101 and the outskirts of the front plate 102 may be substantially the same when viewed from above the front plate 102.

In an embodiment, a surface (or the front plate 102) of the housing 110 may include a display area, through which the display 101 is visually exposed and in which contents are displayed through pixels. For example, the display area may include the first surface 110A, and the first areas 110D of the side surface.

In another embodiment (not illustrated), the display areas 110A and 110D may include a sensing area (not illustrated) configured to acquire biometric information of a user. Here, the expression that "the display areas 110A and 110D include a sensing area" may be understood that at least a portion of the sensing area may overlap the display areas 110A and 110D. For example, the sensing area (not illustrated) may display contents on the display 101 like other areas of the screen display areas 110A and 110D, and additionally, may mean an area that may acquire biometric information (e.g., a fingerprint) of the user.

In an embodiment, the display areas 110A and 110D of the display 101 may include a camera area 106. For example, the camera area 106 may be an area, through which light reflected by a subject and received by the first camera module 105 passes. For example, the camera area 106 may be an area, through which an optical axis of the first camera module 105 passes. Here, the expression that "the display areas 110A and 110D include the camera area 106" may be understood that at least a portion of the camera area 106 may overlap the display areas 110A and 110D. For example, in the camera area 106, contents may be displayed on the display 101 as in another area of the display areas 110A and 110D.

In various embodiments (not illustrated), the screen display areas 110A and 110D of the display 101 may include an area, in which the first camera module 105 (e.g., a punch hole camera) may be visually exposed. For example, at least a portion of an edge of the exposed area of the first camera module 105 may be surrounded by the screen display areas 110A and 110D. In an embodiment, the first camera module 105 may include a plurality of camera modules.

In an embodiment, at least one of the audio modules 103, 104, and 107, the sensor modules (not illustrated), the camera module (e.g., the first camera module 105), and the light emitting elements (not illustrated) may be included on the rear surface of the screen display areas 110A and 110D of the display 101. For example, in the electronic device 100, the camera module (e.g., the first camera module 105) may be disposed on the rear surface of the first surface 110A (e.g., the first surface) and/or a rear surface (e.g., a surface that faces the -X axis direction) of the side surface 110C (e.g., at least one surface of the first area 110D) to face the first surface 110A and/or the side surface 110C. For example, the first camera module 105 may not be visually exposed to the screen display areas 110A and 110D, and may include an under display camera (UDC).

In other embodiments (not illustrated), the display 101 may include or be disposed to be adjacent to a touch detection circuit, a pressure sensor that may measure the strength (the pressure) of a touch, and/or a digitizer that detects a stylus pen of a magnetic field type.

According to an embodiment, the audio modules 103, 104, and 107 may include the microphone holes 103 and 104 and the speaker hole 107.

In an embodiment, the microphone holes 103 and 104 may include the first microphone hole 103 formed in a partial area of the side surface 110C, and the second microphone hole 104 formed in a partial area of the second surface 110B. Microphones for obtaining external sound may be disposed in interiors of the housing 110. The microphones may include a plurality of microphones to sense a direction of sound. In an embodiment, the second microphone hole 104 formed in a partial area of the second surface 110B may be disposed to be adjacent to the camera modules 105 and 112. For example, the second microphone hole 104 may acquire sound during execution of the camera modules 105 and 112 or may acquire sound during execution of another function.

In an embodiment, the speaker hole 107 may include a communication receiver hole (not illustrated). The speaker hole 107 may be formed at a portion of the side surface 110C of the electronic device 100. In another embodiment, the speaker hole 107 and the microphone hole 103 may be implemented with one hole. Although not illustrated, the communication receiver hole (not illustrated) may be formed at another portion of the side surface 110C. For example, the communication receiver hole (not illustrated) may be formed at a portion (e.g., a portion that faces the +Y axis direction) of the side surface 110C, which faces a portion (e.g., a portion that faces the -Y axis direction) of the side surface 110C, at which the speaker hole 107 is formed.

In an embodiment, the electronic device 100 may include a speaker fluid-communicated with the speaker hole 107. In another embodiment, the speaker may include a piezoelectric speaker, from which the speaker hole 107 is omitted.

In an embodiment, the sensor module (not illustrated) may generate an electrical signal or a data value corresponding to an operation state of the interior of the electronic device 100 or an environmental state of the outside. In an embodiment, the sensor module (not illustrated) may be disposed at at least a portion of the first surface 110A, the second surface 110B, and the side surface 110C (e.g., the first areas 110D and/or the second areas 110E) of the housing 110, and may be disposed (e.g., a fingerprint sensor) on the rear surface of the display 101. For example, at least a portion of the sensor module (not illustrated) may be disposed under the display areas 110A and 110D not to be visually exposed, and a sensing area (not illustrated) may be formed at at least a portion of the display areas 110A and 110D. For example, the sensor module (not illustrated) may include an optical fingerprint sensor. In some embodiments (not illustrated), the fingerprint sensor may be disposed not only on the first surface 110A (e.g., the screen display areas 110A and 110D) but also on the second surface 110B of the housing 110. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, and an illumination sensor.

In an embodiment, the key input device 117 may be disposed in the side surface 110C (e.g., the first areas 110D and/or the second areas 110E) of the housing 110. In another embodiment, the electronic device 100 may not include some or all of the above-mentioned key input devices 117 and the key input devices 117, which are not included, may be realized in different forms, such as a soft key, on the display 101. In another embodiment, the key input device may include a sensor module (not illustrated) that defines a sensing area (not illustrated) included in the display areas 110A and 110D.

In an embodiment, the connector hole 108 may accommodate connectors. The connector hole 108 may be disposed on the side surface 110C of the housing 110. For example, the connector hole 108 may be disposed on the side surface 110C to be adjacent to at least a portion of the audio modules (e.g., the microphone hole 103 and the speaker hole 107). In another embodiment, the electronic device 100 may include the first connector hole 108 that may accommodate a connector (e.g., a USB connector) for transmitting and receiving electric power and/or data to and from an external electronic device and/or a second connector hole (not illustrated) that may accommodate a connector (e.g., an earphone jack) for transmitting and receiving an audio signal to and from the external device.

In an embodiment, the electronic device 100 may include a light emitting element (not illustrated). For example, the light emitting element (not illustrated) may be disposed on the first surface 110A of the housing 110. The light emitting element (not illustrated) may provide state information on the electronic device 100 in the form of light. In another embodiment, the light emitting element (not illustrated) may provide a light source that interworks with an operation of the first camera module 105. For example, the light emitting element (not illustrated) may include an LED, an IR LED, and/or a xenon lamp.

In an embodiment, the camera modules 105 and 112 may include the first camera module 105 (e.g., an under display camera) that receive light through the camera area 106 of the first surface 110A of the electronic device 100, the second camera module 112 that receives light through a partial area (e.g., the rear camera area 184 of FIG. 3) of the second surface 110B, and the flash 113.

In an embodiment, the first camera module 105 may include an under display camera (UDC) disposed on a rear surface of the display 101. For example, the first camera module 105 may be located in some layers of the display 101, or may be located such that an optical axis of a lens passes through the display areas 110A and 110D. In various embodiments, the first camera module 105 may be configured to receive light though the camera area 106 included in the display areas 110A and 110D. For example, the camera area 106 may be configured to display contents like other areas of the display areas 110A and 110D when the first camera module 105 is not operated. For example, when the first camera module 105 is operated, the camera area 106 does not display contents and the first camera module 105 may receive light through the camera area 106.

In various embodiments (not illustrated), the first camera module 105 (e.g., a punch hole camera) may be exposed through a portion of the display areas 110A and 110D of the display 101. For example, the first camera module 105 may be exposed through a partial area of the screen display areas 110A and 110D through an opening formed at a portion of the display 101.

In an embodiment, the second camera module 112 may include a plurality of camera modules (e.g., a dual camera, a triple camera, or a quad camera). However, the second camera module 112 is not limited to necessarily include a plurality of camera modules, and may include one camera module.

In an embodiment, the first camera module 105 and/or the second camera module 112 may include one or a plurality of lenses, an image sensor, and/or an image signal processor. The flash 113, for example, may include a light emitting diode or a xenon lamp. In another embodiment, two or more lenses (an infrared ray camera, and a wide angle/telephoto lens), and image sensors may be disposed on one surface of the electronic device 100 (e.g., in an interior of the housing to face a direction, which the second surface 110B faces).

Referring to FIG. 3, the electronic device 100 may include the side bezel structure 118, a first support member 140 (e.g., the bracket), the front plate 120 (e.g., the front plate 102 of FIG. 1), a display 130 (e.g., the display 101 of FIG. 1), a printed circuit board 150 (e.g., a printed circuit board (PCB), a flexible PCB (FPCB), or a rigid-flexible PCB (RFPCB)), a battery 153, a second support member 160 (e.g., the rear case), an antenna 170, and/or the rear plate 180 (e.g., the rear plate 111 of FIG. 2). In some embodiments, at least one (e.g., the first support member 140 or the second support member 160) of the elements may be omitted from the electronic device 100 or another component may be additionally included in the electronic device 100. At least one of the components of the electronic device 100 may be the same as or similar to at least one of the components of the electronic device 100 of FIGS. 1 and 2, and a repeated description thereof will be omitted.

In an embodiment, the first support member 140 may be disposed in the interior of the wearable electronic device 100 to be connected to the side bezel structure 118 or to be integrally formed with the side bezel structure 118. The first support member 140, for example, may be formed of a metal material and/or a nonmetal material (e.g., a polymer). The display 130 may be coupled to or located on one surface of the first support member 140, and the printed circuit board 150 may be coupled to or located on an opposite surface of the first support member 140.

In an embodiment, a processor, a memory, and/or an interface may be mounted on the printed circuit board 150. The processor, for example, may include one or more of a central processing unit, an application processor, a graphic processing unit, an image signal processor, a sensor hub processor, or a communication processor.

In an embodiment, the memory, for example, may include a volatile and/or nonvolatile memory.

In an embodiment, the interface, for example, may include a high definition multimedia interface (HDMI), a universal serial bus (USB), an SD card interface, and/or an audio interface. The interface, for example, may electrically or physically connect the electronic device 100 to an external electronic device, and may include a USB connector, an SD card/MMC connector, and an audio connector.

According to an embodiment, the battery 153 is a device for supplying electric power to at least one component of the electronic device 100, and for example, may include a primary battery that cannot be recharged, a secondary battery that may be recharged, or a fuel cell. At least a portion of the battery 153, for example, may be disposed on substantially the same plane as the printed circuit board 150. The battery 153 may be integrally disposed in the interior of the electronic device 100, and may be disposed to be detachable from the electronic device 100.

According to an embodiment, the antenna 170 may be disposed between the rear plate 180 and the battery 153. The antenna 170, for example, may include a near field communication (NFC) antenna, a wireless charging antenna, and/or a magnetic secure transmission (MST) antenna. The antenna 170, for example, may perform short-range communication with an external device, or may wirelessly transmit and receive electric power that is necessary for charging. In another embodiment, an antenna structure may be formed by one or a combination of the side bezel structure 118 and/or the first support member 140.

In an embodiment, the first camera module 105 may be coupled to the rear surface of the display 130 to receive light through the camera area 106 of the front plate 120. For example, at least a portion of the first camera module 105 may be disposed in the first support member 140. For example, an image sensor of the first camera module 105 may receive light that passes through the camera area 106, and a pixel array included in the display 130. For example, the camera area 106 may at least partially overlap the display area, on which contents are displayed. For example, an optical axis OA the first camera module 105 may pass through a partial area of the display 130 and the camera area 106 of the front plate 120. For example, the partial area may include a pixel array including a plurality of light emitting elements. In an embodiment, a partial area of the display 130, which faces the first camera module 105, may be a portion of the display area, on which the contents are displayed, and may be a transmission area having a specific transmittivity. In an embodiment, the transmission area may be formed to have a transmittivity ranging from about 5% to about 25%. In an embodiment, the transmission are may be formed to have a transmittivity ranging from about 25% to about 50%. In an embodiment, the transmission area may be formed to have a transmittivity of about 50% or more. The transmission area may include an area that overlaps an effective area (e.g., a field of view (FOV)) of the first camera module 105, through which light for generating an image by forming the image with an image sensor. For example, the transmission area of the display 130 may include an area having a low density and/or a low wiring density of pixels.

In an embodiment, the second camera module 112 may be disposed such that the lens is exposed through the rear camera area 184 of the rear plate 180 (or the rear surface 110B of FIG. 2) of the electronic device 100. The rear camera area 184 may be formed at at least a portion of a surface (e.g., the rear surface 110B of FIG. 2) of the rear plate 180. In an embodiment, the rear camera area 184 may be formed to be at least partially transparent such that the second camera module 112 receives external light through the rear camera area 184.

In an embodiment, at least a portion of the rear camera area 184 may protrude from the surface of the rear plate 180 by a specific height. However, the disclosure is not limited thereto, and the rear camera area 184 may define a plane that is substantially the same as the surface of the rear plate 180.

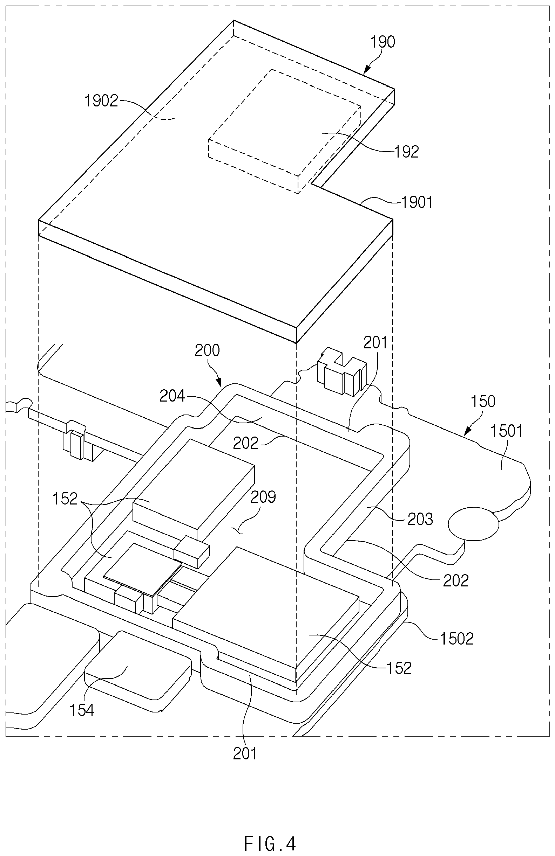

FIG. 4 is a view illustrating an electronic device according to an embodiment.

Referring to FIG. 4, the electronic device 100 may include an interposer 200 (e.g., a shielding member) that electrically connects the first board 150 (e.g., the printed circuit board 150 of FIG. 3) and the second board 190. In an embodiment, the interposer 200 may define a shielding space 209 that may shield noise generated between the first board 150 and the second board 190 or introduced from an outside. In an embodiment, the interposer 200 may be provided in various shapes. For example, the interposer 200 may be provided in a polygonal shape. The interposer 200 may be provided in a ring shape that surrounds the shielding space 209. The shielding space 209 may include a partial area of the first board 150 and a partial area of the second board 190. A shape of the interposer 200 disclosed in the disclosure is not limited to those illustrated in the drawings.

In an embodiment, the first board 150 (e.g., the printed circuit board 150 of FIG. 3) may include one or more electric elements 152 and 154, a signal line that electrically connects the electric elements 152 and 154, and a ground(or ground line). In an embodiment, the one or more electric elements 152 and 154 may include the first electric element 152 located in an interior of the shielding space 209 and the second electric element 154 located on an outside of the shielding space 209. In an embodiment, the first board 150 may include a first upper surface 1501 that faces a second lower surface 1902 of the second board 190, and a first lower surface 1502 that is opposite to the first upper surface 1501. Referring to the drawings, a partial area of the first upper surface 1501 of the first board 150 may be included in the shielding space 209. For example, the first upper surface 1501 of the first board 150 may define the shielding space 209 together with the interposer 200. The first electric element 152 and the second electric element 154 may be disposed on the first upper surface 1501.

In an embodiment, the second board 190 may be located in a first direction of the first board 150. For example, the second board 190 may be disposed above the first upper surface 1501 of the first board 150 or may be disposed below the first lower surface 1502 of the first board 150. A location of the second board 190 may be changed according to a kind and/or a function of a third electric element 192 mounted on the second board 190. The third electric element 192 may be located in an interior of the shielding space 209. Referring to the drawings, the third electric element 192 may be disposed on the second lower surface 1902 of the second board 190. The second board 190 may include the second lower surface 1902 that faces the first upper surface 1501 of the first board 150, and the second upper surface 1901 that is opposite to the second lower surface 1902. Referring to the drawings, at least a partial area of the second lower surface 1902 of the second board 190 may be included in the shielding space 209. For example, the second lower surface 1902 of the second board 190 may define the shielding space 209 together with the interposer 200. The shielding space 209 may include a space at least partially closed by the first upper surface 1501 of the first board 150, the second lower surface 1902 of the second board 190, and the interposer 200.

In one embodiment, the interposer 200 may be disposed between the first board 150 and the second board 190. In an embodiment, the interposer 200 may extend to surround the shielding space 209 defined between the first board 150 and the second board 190. For example, the interposer 200 may include a second surface 202 that at least partially contacts the first upper surface 1501 of the first board 150, a first surface 201 that at least partially contacts the second lower surface 1902 of the second board 190, and side surfaces 203 and 204 that surrounds a space between the first surface 201 and the second surface 202.

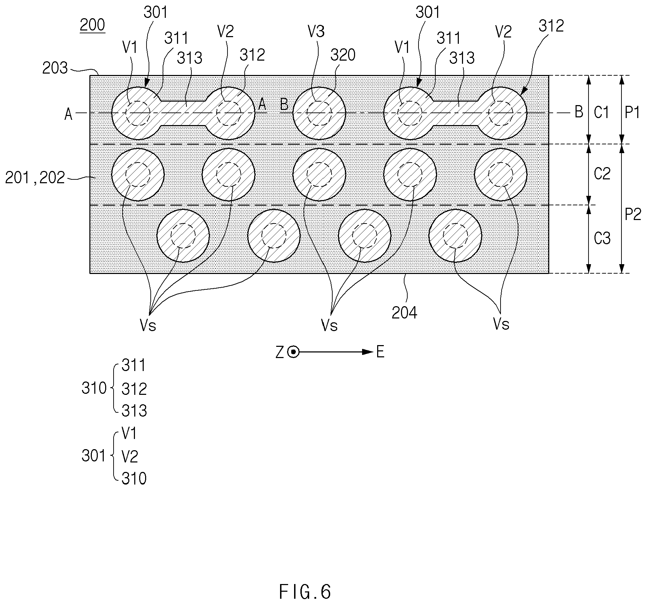

In an embodiment (not illustrated), the interposer 200 may connect the flexible circuit board and a main circuit board (e.g., the first board 150). For example, the second board 190 may be a flexible circuit board. For example, the interposer 200 may be a conductive member that connects a joining part of the flexible circuit board and the main circuit board. In an embodiment, the interposer 200 may include a plurality of vias (e.g., a plurality of vias Vs, V1, V2, and V3 of FIG. 6), and may be disposed coaxially with the joining part of the flexible circuit board. Furthermore, during a joining process of the flexible circuit board and the main circuit board (e.g., a hot bar process), a conductive material such as lead may be jointed to the plurality of vias to form a signal transmission structure between the flexible circuit board and the main circuit board.

In various embodiments, the second board 190 may have various sizes. For example, the second board 190 may have the same size as that of the first board 150, may have a size that is smaller than that of the first board 150, or may have a size that is larger than that of the first board 150. The second board 190 may have a shape corresponding to the shape of the interposer 200. The shapes of the first board 150 and the second board 190, which are illustrated in the drawings, are merely an example, and the boards may have various shapes.

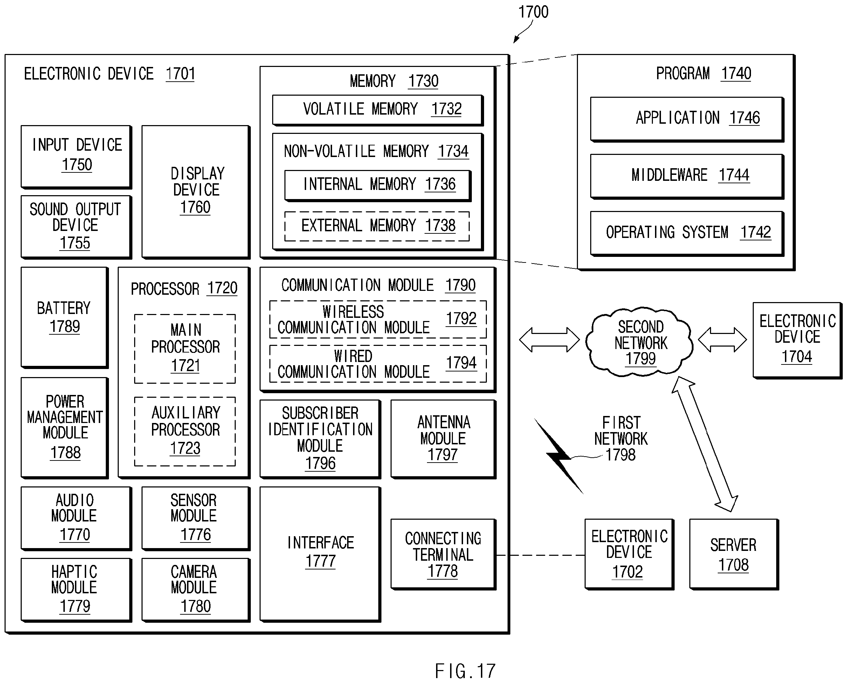

In an embodiment, each of the first electric element 152, the second electric element 154, and the third electric element 192 may include an integrated circuit, an active element, or a passive element. For example, the first electric element 152 and the third electric element 192 disposed in an interior of the shielding space may include an electric element that requires shielding due to a high noise vulnerability as compared with the second electric element 154 or generates much noise. For example, the first electric element 152 may include a processor (e.g., a processor 1720 of FIG. 17) (e.g., an application processor AP) and/or a call processor (CP), a memory (e.g., a memory 1730 of FIG. 17), and a power management circuit (e.g., a power management module 1788 of FIG. 17). Furthermore, the third electric element 192 may include an RF circuit (e.g., a communication module 1790 of FIG. 17), an NFC chip, a UWV chip, a sensor circuit (e.g., a sensor module 1776 of FIG. 17), a transceiver, a wireless communication module (e.g., a Wi-Fi module), and a connector module (e.g., a connecting terminal 1778 of FIG. 17) for connection with an external electronic device. The connector module may include an IF C type connector, a display connector, and a battery connector.

In an embodiment, the interposer 200 may include a plurality of signal vias (e.g., the signal vias Vs of FIG. 6) (e.g., a power interface, an USB interface, an MIPI interface, an RF interface, through electrodes, and wiring lines), and ground vias (e.g., the ground vias V1, V2, and V3) (e.g., a ground (GND) terminal). For example, the first board 150 and the second board 190 may be electrically connected to each other by the interposer 200, and the first board 150 may deliver a digital signal related to a radio frequency (RF) band to the second board 190 through the interposer 200.

According to an embodiment, because some electric elements are disposed in the second board 190, the interior space of the electronic device 100 may be efficiently utilized. According to an embodiment, because the interposer 200 performs a shielding function in addition to the electrical connection of the first board 150 and the second board 190, a separate shield may not be required.

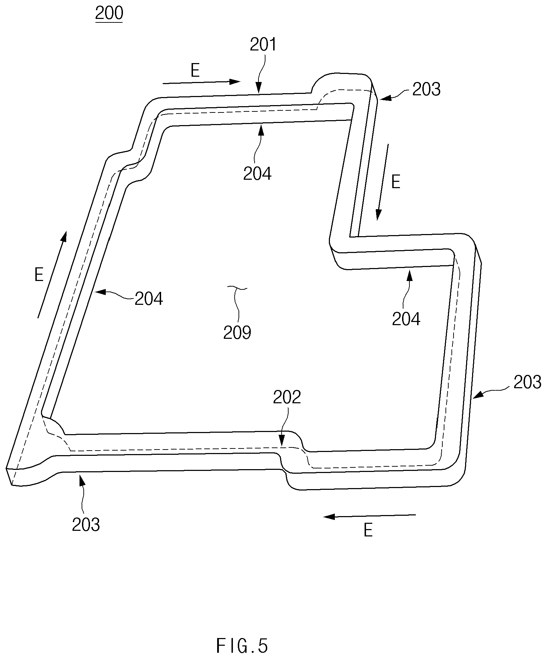

FIG. 5 is a view illustrating an interposer of an electronic device according to an embodiment.

Referring to FIG. 5, the interposer 200 may extend in a close form to surround the interior space 209. In an embodiment, an extension direction "E" of the interposer 200 may be a direction (e.g., the x axis and the y axis of FIGS. 1 and 2) that is substantially perpendicular to the z axis (e.g., the z axis of FIGS. 1 and 2). In another embodiment, the extension direction "E" of the interposer 200 may include a direction that is formed on the x-y plane, in addition to the illustrated direction. For example, the extension direction "E" may include a diagonal direction in the x-y plane. For example, the extension direction "E" may include an arbitrary direction made by combining an x axis direction vector and a y axis direction vector. The interposer 200 may include a linear section that extends substantially in a straight line, and a curved section that extends in a curved line. In an embodiment, electric elements (e.g., the first electric element 152 and the third electric element 192) mounted on the first board 150 and/or the second board 190 may be located in the interior space 209.

In an embodiment, the interposer 200 may include the first surface 201, the second surface 202, the outer surface 203, and the inner surface 204. The inner surface 204 may be a surface that faces the interior space 209. The outer surface 203 may be a surface that faces an outside of the interposer 200.

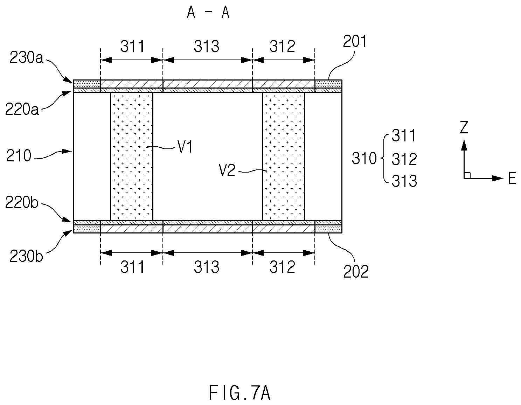

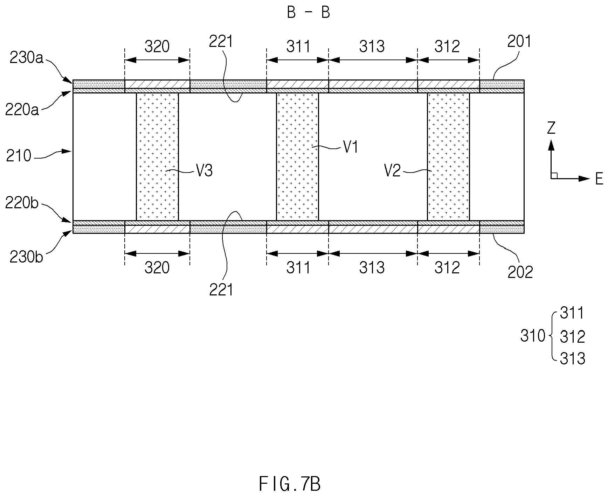

In an embodiment, the first surface 201 of the interposer 200 may include a first cover layer (e.g., a first cover layer 230a of FIG. 7A), and a conductive pad (e.g., a first pad 310 and a second pad 320 of FIG. 7B) formed in an opened area of the first cover layer 230a. For example, the conductive pad included on the first surface 201 may at least partially contact a conductive area of the second board 190 to be electrically connected thereto. For example, the conductive pad included on the first surface 201 may be coupled to the conductive area of the second board 190 through soldering.

In an embodiment, the second surface 202 of the interposer 200 may include a second cover layer (e.g., a second cover layer 230b of FIG. 7A), and the conductive pad (e.g., the first pad 310 and the second pad 320 of FIG. 7A) formed in an opened area of the second cover layer 230b. For example, the conductive pad included on the second surface 202 may at least partially contact a conductive area of the first board 150 to be electrically connected thereto. For example, the conductive pad included on the second surface 202 may be coupled to the conductive area of the first board 150 through soldering.

In an embodiment, the interposer 200 may have a structure including a plurality of layers. For example, the interposer 200 may include a plurality of insulation parts including an insulating material. For example, the insulating material may include preimpregnated materials (PPG) (PREPREG), and copper clad laminates may be disposed between the insulating materials.

FIG. 6 is a plan view of an interposer according to an embodiment. FIG. 7A is a cross-sectional view of an interposer according to an embodiment. FIG. 7B is a cross-sectional view of an interposer according to an embodiment.

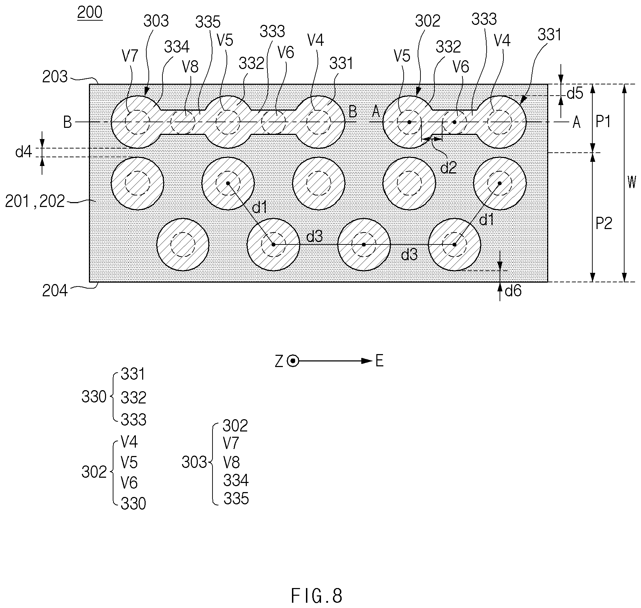

Referring to FIG. 6, the interposer 200 may include the plurality of vias Vs, V1, V2, and V3. The plurality of vias Vs, V1, V2, and V3 may include the signal vias Vs that connect the first board (e.g., the first board 150 of FIG. 4) and the second board (e.g., the second board 190 of FIG. 4), and the ground vias V1, V2, and V3 that connect ground area of the first board 150 and the second board 190. In various embodiments, the ground vias described in the disclosure may include vias V4 to V11 illustrated in FIGS. 8 to 15, in addition to the vias V1, V2, and V3 illustrated in FIGS. 6 to 7B.

In an embodiment, the interposer 200 may fill a conductive material (or a conductive substance) in interiors of the one or more vias Vs, V1, V2, and V3 through hole plugging, but the disclosure is not limited thereto.

In an embodiment (not illustrated), the forms of the plurality of vias Vs, V1, V2, and V3 are not limited to those illustrated in the drawings. For example, at least some of the plurality of vias Vs, V1, V2, and V3 may be in a form of slots. For example, the vias in the form of slots may be in a form of openings having a length in the extension direction "E". For example, the vias in the form of slots may be formed by continuously performing hole plugging such that the plurality of vias Vs, V1, V2, and V3 illustrated are not spaced apart from each other.

Referring to FIG. 6, the interposer 200 may include a plurality of pads 310 and 320 formed on a surface thereof and electrically connected to the signal vias Vs and the ground vias V1, v2, and V3, respectively. Each of the plurality of pads 310 and 320 may be connected to one or two or more vias. When the surface (e.g., the first surface 201 or the second surface 202) of the interposer 200 is viewed from a top (e.g., the z axis direction), each of the plurality of pads 310 and 320 may overlap at least one via.

In an embodiment, the pads connected to the signal vias Vs may be electrically connected to a signal line of the first board 150 or the second board 190. In an embodiment, the pads connected to the ground vias V1, V2, and V3 may be electrically connected to a ground area of the first board 150 or the second board 190.

In various embodiments, the first part P1, in which the ground vias V1 and V2 are disposed, is not necessarily defined in a first column C1. For example, the first part P1 of the interposer 200 may be partially provided for connection of an antenna. In this case, some of the ground vias V1 and V2 may be located in a second column C2 or a third column C3, and may form a fence with the ground vias V1 and V2 disposed in the first column C1. The signal vias Vs of the interposer 200, and the interior space may be located in an interior of the fence, and the vias provided for connection of the antenna may be located outside the fence.

Referring to FIG. 7A, the plurality of vias V1, V2, and V3 may extend long in the z axis direction to pass through an insulation layer 210. For example, lengthwise directions of the plurality of vias V1, V2, and V3 may be defined as directions that are substantially parallel to the z axis.

In an embodiment, the interposer 200 may include the first part P1, and a second part P2 surrounded by the first part P1. The first part P1 may be defined along the outer surface 203 of the interposer 200. In an embodiment, the first part P1 may be configured to shield the interior space 209 surrounded by the interposer 200, and the second part P2 of the interposer 200. For example, the first part P1 may prevent or restrain noise generated from the interior space 209 or the second part P2 from being discharged to the outside of the interposer 200, and may prevent or restrain noise generated from the outside from being introduced into the interior space 209 or the second part P2 of the interposer 200.

In an embodiment, the first part P1 of the interposer 200 may include the ground vias V1, V2, and V3. For example, only the ground vias V1, V2, and V3 may be disposed in the first part P1, and the signal vias Vs may not be disposed in the first part P1. In another embodiment (not illustrated), the first part P1 of the interposer 200 may include the ground vias V1, V2, and V3, and the signal vias Vs, and an area, in which the ground vias V1, V2, and V3 are disposed, may be wider than an area, in which the signal vias Vs are disposed.

In various embodiments, the second part P2 of the interposer 200 may include the signal vias Vs and the ground vias. In the second part P2 of the interposer 200, the number of the signal vias Vs may be larger than the number of the ground vias. In an embodiment, the sizes of the signal vias Vs and the ground vias may be different. For example, the signal vias Vs may be formed to have a first size (diameter) when viewed in the z axis direction, and the ground vias may be formed to have a second size (diameter) that is smaller than the first size (diameter). For example, the interposer 200 may be machined to have different forms, based on a size of a drill and/or the number of drillings in a process of forming the one or more vias Vs, V1, V2, and V3. However, the drilling is merely an example of machining schemes of forming the one or more vias Vs, V1, V2, and V3, and the one or more vias Vs, V1, V2, and V3 may be formed through laser machining or punching.

In an embodiment, the second part P2 of the interposer 200 may be configured such that the first area, in which the signal vias Vs are disposed, is larger than the second area, in which the ground vias are disposed. For example, when the size (diameter) of the signal vias Vs disposed in the first area is larger than the size (diameter) of the ground vias disposed in the second area, the first area may have an area that is larger than that of the second area, and the number of the signal vias Vs of the first area may be the same as that of the ground vias of the second area.

In an embodiment, the second part P2 of the interposer 200 may be configured such that the first area, in which the signal vias Vs are disposed, has the same area as that of the second area, in which the ground vias are disposed. For example, when the size (diameter) of the signal vias Vs disposed in the first area is larger than the size (diameter) of the ground vias disposed in the second area, the first area may have the same area as that of the second area, and the number of the signal vias Vs of the first area may be smaller than that of the ground vias of the second area.

In various embodiments, when the surfaces 201 and 202 of the interposer 200 is viewed from a top, an area occupied by the first part P1 may be smaller than an area occupied by the second part P2. The number of the vias (e.g., the ground vias) included in the first part P1 may be smaller than the number of the vias included in the second part P2. In this way, the interposer 200 according to the embodiment may provide a larger number of signal vias than an interposer of the comparative embodiment of the same size. For example, in the interposer of the comparative embodiment, the areas of the first part P1 and the second part P2 are substantially the same. The interposer 200 according to embodiments has a decreased area of the first part P1 and an increased area of the second part P2, as compared with the interposer of the comparative embodiment, and thus a total number of the vias formed in the interposer 200 may be increased. For example, the increased number of vias is used mainly for the signal vias Vs, and thus a larger number of signals may be processed. As another example, because a shielding function (e.g., a shield can) of the interposer 200 is provided by using the ground vias included in the first part P1, the ground vias disposed in the second part of the existing interposer may be used as signal vias. Accordingly, the interposer 200 may provide a larger number of signal vias Vs.

In an embodiment, the vias V1, V2, V3, and Vs provided in the interposer 200 may form a plurality of columns. The columns of the interposer 200 may be defined substantially along the extension direction "E". For example, referring to the drawings, in the interposer 200, the first column C1 that is adjacent to the outer surface 203, the third column C3 that is adjacent to the inner surface 204, and the second column C2 between the first column C1 and the third column C3 may be defined. However, the interposer 200 is not necessarily limited to include three columns. For example, the interposer 200 may include three or more columns. In an embodiment, the ground vias V1, V2, and V3 may be disposed in the first column C1 that is adj acent to the outer surface 203 of the interposer 200 for the shielding performance. The signal vias Vs may be disposed in the second column and/or the third column. In various embodiments, some ground vias may be disposed in the second column C2 and/or the third column C3. For example, the first part P1 of the interposer 200 may include the ground vias V1, V2, and V3 disposed in the first column C1 of the interposer 200.

Referring to FIGS. 7A and 7B, the interposer 200 may include the insulation layer 210, a first conductive layer 220a and a second conductive layer 220b disposed on opposite surfaces of the insulation layer 210, and the first cover layer 230a and the second cover layer 230b disposed on surfaces of the conductive layers 220a and 220b. For example, the first conductive layer 220a may be disposed between the first cover layer 230a and the insulation layer 210. For example, the second conductive layer 220b may be disposed between the second cover layer 230b and the insulation layer 210. For example, the first cover layer 230a may define the first surface 201 of the interposer 200, and the second cover layer 230b may define the second surface 202 of the interposer 200. In an embodiment, each of the first conductive layer 220a and the second conductive layer 220b may include the first pad 310, the second pad 320, and a first conductive pattern 221. In an embodiment, the vias V1, V2, V3, and Vs of the interposer 200 may be filled with a filler member. For example, the vias V1, V2, V3, and Vs may be formed by primarily plating inner walls of the via holes and filling the filler member (e.g., a dielectric material) in the interiors of the plated via holes. In an embodiment, the filler member may be formed by filling the dielectric material (e.g., photo imageable solder resist mask (PSR) ink) in a paste state or an ink state and curing the dielectric material. For example, the filler member may prevent an electric short-circuit between the adjacent vias V1, V2, V3, and Vs. Referring to FIGS. 7A and 7B, the ground vias V1, V2, and V3 may overlap the pads 311, 312, and 320 when the first surface 201 or the second surface 202 is viewed in the z axis direction. However, relationships between the ground vias V1, V2, and V3 and the pads 311, 312, and 320 are not limited to those illustrated. For example, the ground vias V1, V2, and V3 may overlap partial areas (e.g., an insulating coating area) of the cover layers 230a and 230b, when the first surface 201 or the second surface 202 is viewed in the z axis direction. For example, the insulating coating area may include a solder resist.

Referring to FIGS. 6 and 7A, the first part P1 may include a first structure 301. In an embodiment, the first structure 301 may include the first via V1 and the second via V2, and the first pad 310 formed on a surface of the interposer 200 and contacting the first via V1 and the second via V2. The first pad 310 may overlap the first via V1 and the second via V2 to cover them when the surface of the interposer 200 is viewed from a top (e.g., when viewed in the z axis direction). For example, the first pad 310 may have an area that is larger than those of the first via hole (e.g., the first via V1) and the second via hole (e.g., the second via V2) to fully cover the first via V1 and the second via V2.

Referring to FIGS. 6 and 7A, the first pad 310 may include a first area 311 that contacts an end of the first via V1, a second area 312 that contacts an end of the second via V2, and a third area 313 that connects the first area 311 and the second area 312. In an embodiment, the end of the first via V1 and the end of the second via V2 may include a conductive area formed on a surface of the insulation layer 210 and defined by the conductive material filled in the via holes. For example, the first area 311 may be formed to be larger than the first via hole to cover the conductive area formed as the first via V1 is exposed to the surface of the insulation layer 210. For example, the second area 312 may be formed to be larger than the second via hole to cover the conductive area formed as the second via V2 is exposed to the surface of the insulation layer 210. In an embodiment, the conductive material may include copper (Cu), lead (Pb), silver (Ag), nickel (Ni), aluminum (Al), tin (Sn), stainless steel, and/or a combination thereof.

In various embodiments, the first area 311 and the second area 312 may have a substantially circular shape, and the third area 313 may have a width that is smaller than diameters defined in the first area 311 and the second area 312. Here, the width may be a distance(or length) measured in a direction that is substantially perpendicular to the extension direction "E" of the interposer 200. In various embodiments, a width of the third area 313 may be smaller than a maximum width (e.g., a maximum diameter) of the first area 311 or the second area 312. In various embodiments, the first pad 310 may have a dumbbell shape.

In an embodiment, shapes of the vias V1, V2, V3, and Vs, and the pads 310 and 320 corresponding to the vias may be variously formed. For example, the first pad 310 and/or the second pad 320 may be circular, elliptical, or polygonal. The first pad 310 and/or the second pad 320 may have the same or different sizes. The first pad 310 and/or the second pad 320 may be disposed to have regular or irregular distances. Furthermore, it should be understood that the same contents are applied to the shapes and/or the distances of the pads disposed in the second part P2.

Referring to FIG. 6, all of the first area 311, the second area 312, and the third area 313 may be formed on a surface of the interposer 200, and may at least partially contact a surface of the first board 150 or the second board 190. In an embodiment, the interposer 200 may include the third area 313, and thus contact areas with the boards 150 and 190 are increased, and the interposer 200 may be coupled to the boards 150 and 190 more firmly due to the increased areas.

Referring to FIGS. 6 and 7B, the first part P1 may include the third via V3, and the second pad 320 that contacts the third via V3. When the surface (e.g., the first surface 201 or the second surface 202) of the interposer 200 is viewed from a top (e.g., the z axis direction), the second pad 320 may overlap the third via V3 to cover the third via V3. For example, the second pad 320 may have an area that is larger than that of the third via hole to fully cover the third via V3. Referring to FIG. 7B, the third via V3 and the second pad 320 may be electrically connected to the first structure 301 through the first conductive pattern 221 included in the conductive layers 220a and 220b. For example, the first conductive pattern 221 may be formed on a surface of the insulation layer 210, and may be disposed between the first cover layer 230a and the insulation layer 210, and between the second cover layer 230b and the insulation layer 210. The second pad 320 may be formed to cover the conductive area defined by the third via V3. The second pad 320 may include a substantially circular periphery when the surface (e.g., the first surface 201 or the second surface 202) of the interposer 200 is viewed from a top. In an embodiment, the second pad 320 may be surface-mounted on the ground area of the first board 150 or the second board 190. In an embodiment, the first pad 310 and/or the second pad 320 may be connected to the first board 150 or the second board 190 by a solder ball, a solder wall, and/or a solder resin. In an embodiment, the solder wall and the solder ball may be formed of the same material. For example, the solder wall and/or the solder ball may include at least one of tin, lead, silver, copper, and zinc.

The interposer 200 may include the first conductive pattern 221 for electrically connecting the first structure 301 and the third via V3. In various embodiments, when the interposer 200 includes the plurality of first structures 301 and the third vias V3, the first conductive pattern 221 may electrically connect the first structures 301 that are adjacent to each other or may electrically connect the third vias V3 that are adjacent to each other. In an embodiment, because the first conductive pattern 221 is covered by the cover layers 230a and 230b, it may not be exposed to the surface (e.g., the first surface 201 or the second surface 202) of the interposer 200. The first structures 301 located on opposite sides of the third via V3 may be electrically connected to each other by the first conductive pattern 221.

In an embodiment, because the first conductive pattern 221 is covered by the cover layers 230a and 230b, mounting areas of the first board 150 and the second board 190 may be efficiently utilized. For example, it is not necessary to dispose a ground pad in areas of the first board 150 and the second board 190, which face the first conductive pattern 221, and a pattern, in which not a ground signal but another signal flows, may be located in the areas. For example, the signal line may be electrically insulated from the first conductive pattern 221 by the cover layers 230a and 230b. For example, solder resists may be formed in the cover layers 230a and 230b. For example, the solder resists may be formed in the remaining areas, except for the area, in which solder (e.g., a solder ball or a solder wall) is formed. Furthermore, the solder resist may be disposed around at least any one of the first pad 310 and the second pad 320. For example, the solder resist may function to protect the interposer 200 from an external impact, moisture, or contaminants.

In various embodiments, although not illustrated in the drawings, the first conductive pattern 221 may extend (e.g., the first column C1) long along the outer surface 203 of the interposer 200 to connect all the ground vias included in the first part P1. In various embodiments, a partial area of the first conductive pattern 221 may define a portion (e.g., the third area 313) of the pad or may be covered by the cover layers 230a and 230b.

In an embodiment, the first part P1 may include the pads 310 and 320 having various forms, the vias V1, V2, and V3, and the first conductive pattern 221 that extends to correspond to the first part P1. The first conductive pattern 221 may connect the vias V1, V2, and V3 to apply the ground signal to all the vias V1, V2, and V3 included in the first part P1. The first conductive pattern 221 may be covered by the cover layers 230a and 230b, or may define a portion (e.g., the third area 313) of the pad (e.g., the first pad 310).

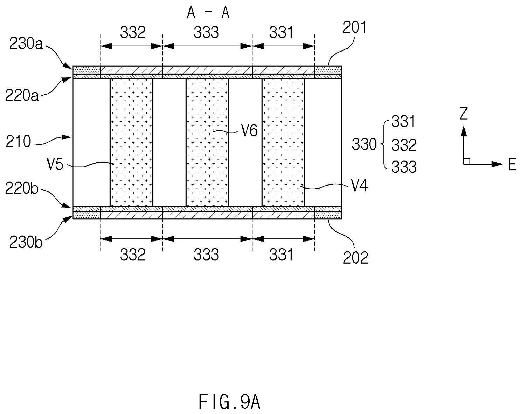

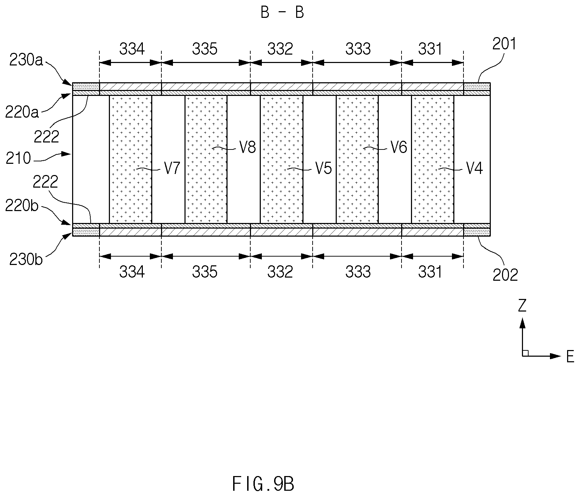

FIG. 8 is a plan view of an interposer according to an embodiment. FIG. 9A is a cross-sectional view of a second structure of an interposer according to an embodiment. FIG. 9B is a cross-sectional view of a third structure of an interposer according to an embodiment.

Hereinafter, in a description of FIGS. 8, 9A, and 9B, repeated contents of the contents described in FIGS. 6, 7A, and 7B may be omitted.

Referring to FIGS. 8 and 9A, the first part P1 of the interposer 200 may include a second structure 302. In an embodiment, the second structure 302 may include a third pad 330, the fourth via V4, the fifth via V5, and the sixth via V6 located on the surface (e.g., the first surface 201 or the second surface 202) of the interposer 200. The ground signal may be applied to the third pad 330, the fourth via V4, the fifth via V5, and the sixth via V6.

In an embodiment, the third pad 330 may include a first area 331 and a second area 332 that partially has a substantially circular or arc-shaped periphery and are spaced apart from each other, and a third area 333 that connects the first area 331 and the second area 332. In an embodiment, the first area 331, the second area 332, and the third area 333 may at least partially contact a surface of the first board 150 or the second board 190. In an embodiment, the first area 331, the second area 332, and the third area 333 may be surface-mounted on the first board 150 or the second board 190. For example, the first area 331, the second area 332, and the third area 333 may be coupled to the first board 150 or the second board 190 through a conductive material (e.g., including at least one of tin, lead, silver, copper, and zinc) For example, the conductive material may include a solder ball, a solder wall, and/or an under-fill resin.

In an embodiment, the interposer 200 may include the third area 333, and thus contact areas with the boards are increased, and the interposer 200 may be coupled to the boards more firmly due to the increased areas.

In an embodiment, the fourth via V4 may overlap the first area 331 of the third pad 330 and contact the first area 331 of the third pad 330, when the surface (e.g., the first surface 201 or the second surface 202) of the interposer 200 is viewed from a top. For example, the first area 331 of the third pad 330 may have an area that is larger than a size of the fourth via hole. In an embodiment, the fifth via V5 may overlap the second area 332 of the third pad 330 and contact the second area 332 of the third pad 330, when the surface (e.g., the first surface 201 or the second surface 202) of the interposer 200 is viewed from a top. For example, the second area 332 of the third pad 330 may have an area that is larger than a size of the fifth via hole. In an embodiment, the sixth via V6 may at least partially overlap the third area 333 of the third pad 330 and contact the third area 333 of the third pad 330, when the surface (e.g., the first surface 201 or the second surface 202) of the interposer 200 is viewed from a top.

In various embodiments, the first area 331 and the second area 332 may have a substantially circular shape, and the third area 333 may have a width that is smaller than diameters defined in the first area 331 and the second area 332. Here, the width may be a distance measured in a direction that is substantially perpendicular to the extension direction "E" of the interposer 200. In various embodiments, a width of the third area 333 may be smaller than a maximum width (e.g., a maximum diameter) of the first area 331 or the second area 332.

In various embodiments, it may be understood that the second structure 302 further includes an additional via (e.g., the sixth via V6) between the first via V1 and the second via V2 of the first structure 301. The second structure 302 may include the vias V4, V5, and V6 arranged at a smaller distance, and through this, an enhanced shielding performance may be provided.

Referring to FIGS. 8 and 9B, the first part P1 of the interposer 200 may include a third structure 303. The third structure 303 may include the second structure 302, a seventh via V7, an eighth via V8, a fourth area 334, and a fifth area 335. A ground signal may be applied to the third structure 303, and the third structure 303 may shield the second part P2 of the interposer 200 and the interior space 209 surrounded by the interposer 200, by forming a shielding wall together with the other vias included in the first part P1, and the other structures (e.g., the first structure 301 and the second structure 302).

In an embodiment, the fourth area 334 may contact an end of the seventh via V7 while partially having a substantially circular or arc-shaped periphery, like the first area 331 or the second area 332. When the surface (e.g., the first surface 201 or the second surface 202) of the interposer 200 is viewed from a top, the fourth area 334 may have an area that is larger than a size of the seventh via hole to fully cover the seventh via V7. In an embodiment, the fifth area 335 may connect the fourth area 334 and the second area 332. In an embodiment, the interposer 200 may include the f area 335, and thus contact areas with the boards 150 and 190 are increased, and may be coupled to the boards 150 and 190 more firmly due to the increased areas. In various embodiments, the fourth area 334 may have a substantially circular shape, and the fifth area 335 may have a width that is smaller than a diameter defined in the fourth area 334.

In an embodiment, the seventh via V7 may overlap the fourth area 334 of the third pad 330 and contact the fourth area 334 of the third pad 330, when the surface (e.g., the first surface 201 or the second surface 202) of the interposer 200 is viewed from a top. In an embodiment, the eighth via V8 may at least partially overlap the fifth area 335 of the third pad 330 and contact the fifth area 335 of the third pad 330, when the surface (e.g., the first surface 201 or the second surface 202) of the interposer 200 is viewed from a top.

In various embodiments, it may be understood that the third structure 303 is configured such that two second structures 302 share one via (e.g., the fifth via V5). The third structure 303 may increase a contact area with the first board 150 or the second board 190 as the third pad 330 extends longer than the second structure 302. Through the increased area, the interposer 200 and the boards 150 and 190 may be coupled to each other more firmly. Furthermore, the third structure 303 further includes the eighth via V8 and the sixth via V6 as compared with the first structure 301, whereby the distances between the vias may be decreased and an enhanced performance may be provided through the decreased distances.

In various embodiments, the second structure 302 and the third structure 303 may be electrically connected to each other through a second conductive pattern 222 formed in the conductive layers 220a and 220b and covered by the cover layers 230a and 230b.

In various embodiments, the second structure 302 and the third structure 303 may be connected to each other in various shapes, in addition to the shape that is connected to each other in the extension direction "E" in the first part P1. For example, the second structure 302 and the third structure 303 may have a zigzag shape. When viewed in the z axis direction, the fourth via V4, the fifth via V5, and the seventh via V7 of the third structure 303 may be formed in substantially the same extension direction "E", and the sixth via V6 and the eighth via V8 may be disposed over or under the extension direction "E" of the fourth via V4, the fifth via V5, and the seventh via V7. For example, the distances between the fourth via V4, the fifth via V5, and the seventh via V7 may be 0.6 mm to 0.8 mm, and the distance between the fourth via V4 and the sixth via V6 may be 0.15 mm to 0.17 mm.

Referring to FIG. 8, a distance d2 between the vias included in the first part P1 may be smaller than or equal to distances d1 and d3 between the vias included in the second part P2. For example, the vias (e.g., the signal vias) included in the second part P2 transmits independent signals, and thus are required to be electrically insulated from each other. Accordingly, in consideration of the areas of the pads, the vias included in the second part P2 may be spaced apart from each other at sufficient distances, by which the pads may be physically separated from each other. Meanwhile, because the vias included in the first part P1 are all ground vias, the same ground signals are applied whereby they may be disposed closer to each other. For example, the pads included in the first part P1 may overlap each other or may be connected to each other. For example, the vias included in the first part P1 may be spaced apart from each other at the second distance d2 of 0.2 mm or less. Then, the second distance d2 may be a distance between outer contour lines of the vias.

In various embodiments, any one of the vias included in the second part P2 may be spaced apart from other adjacent vias located in the extension direction at the third distance d3. In various embodiments, any one of the vias included in the second part P2 may be spaced apart from other adjacent vias located in a direction other than the extension direction at the first distance d1. For example, the first distance d1 may be 0.5 mm to 0.8 mm. The third distance d3 may be 0.6 mm to 0.8 mm. The first distance d1 may be smaller than the third distance d3. The first distance d1 and the third distance d3 may be a distance between the centers of the vias.

Referring to FIG. 8, the pads connected to the vias (e.g., the sixth via V6, the seventh via V7, and the eighth via V8) included in the first part P1 and the pads connected to the via included in the second part P2 may be spaced apart from each other by a fourth distance d4. For example, the fourth distance d4 may be a distance for preventing a short-circuit between the ground vias and the signal vias. Then, the fourth distance d4 may be a distance measured in a direction (e.g., a width (w) direction of the interposer 200) that is substantially perpendicular to the extension direction "E" and the z axis. The fourth interval d4 may be 0.12 mm to 0.18 mm. The fourth interval d4 may be a distance between outer contour lines of the pads. Referring to FIG. 8, a width "w" of the interposer may be 1.5 mm to 2 mm.

Referring to FIG. 8, the vias and the pads that are adjacent to the outer surface 203 may be spaced apart from the outer surface 203 in the widthwise direction by a fifth distance d5. For example, the fifth distance d5 may be a distance between the pads and the outer surface. For example, the fifth distance d5 may be 0.2 mm to 0.3 mm. Referring to FIG. 8, the vias and the pads that are adjacent to the inner surface 204 may be spaced apart from the inner surface 204 in the widthwise direction by a sixth distance d6. For example, the sixth distance d6 may be a distance between the pads and the outer surface. For example, the sixth distance d6 may be 0.2 mm to 0.3 mm.

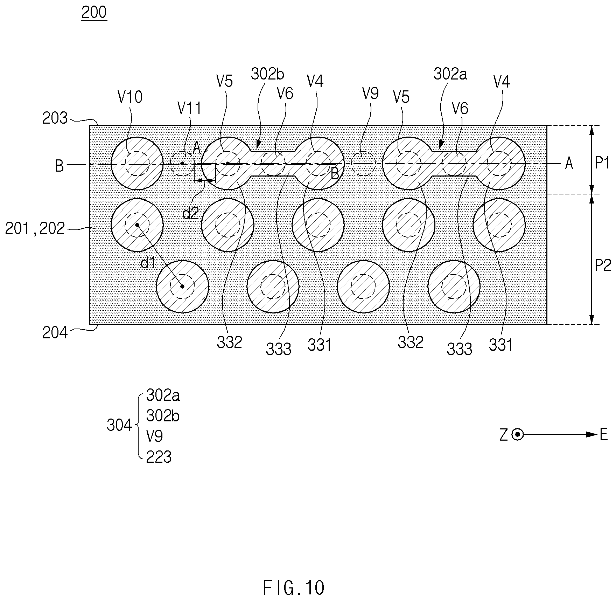

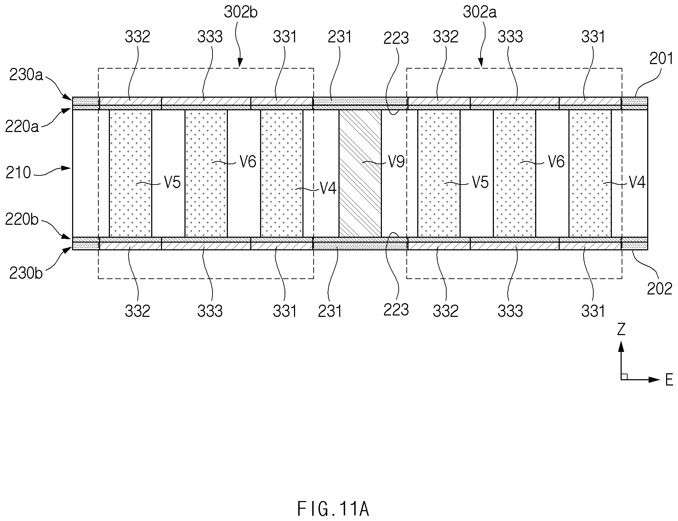

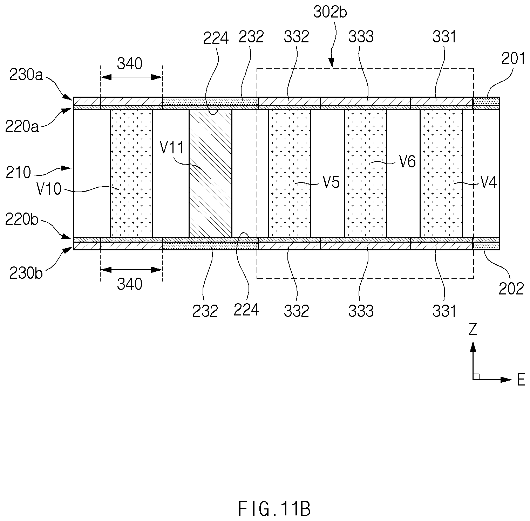

FIG. 10 is a plan view of the interposer according to an embodiment. FIG. 11A is a cross-sectional view of a first part of the interposer according to an embodiment. FIG. 11B is a cross-sectional view of the first part of the interposer according to an embodiment.

Hereinafter, in a description of FIGS. 10, 11A, and 11B, repeated contents of the contents described in FIGS. 6, 7A, 7B, 8, 9A, and 9B may be omitted.

Referring to FIGS. 10 and 11A, the first part P1 may include a fourth structure 304. In an embodiment, the fourth structure 304 may include a 2a-th structure 302a, a 2b-th structure 302b, a ninth via V9, and a third conductive pattern 223. The third conductive pattern 223 may electrically connect the 2a-th structure 302a, the 2b-th structure 302b, and the ninth via V9. The 2a-th structure 302a and the 2b-th structure 302b may be substantially the same as the second structure 302 illustrated in FIGS. 8 and 9A. For example, each of the 2a-th structure 302a and the 2b-th structure 302b may include the third pad 330, the fourth via V4, the fifth via V5, and the sixth via V6, and the third pad 330 may include the first area 331, the second area 332, and the third area 333.

Referring to FIG. 11A, the ninth via V9 may be formed between the first cover layer 230a and the second cover layer 230b, unlike the fourth to eighth vias V4 to V8. For example, when the surface (e.g., the first surface 201 or the second surface 202) of the interposer 200 is viewed from a top, the ninth via V9 may be covered by a first insulation area 231 of the first cover layer 230a or the second cover layer 230b not to be exposed to the surface of the interposer 200. For example, when the surface (e.g., the first surface 201 or the second surface 202) of the interposer 200 is viewed from a top, the other vias (e.g., the fourth to sixth vias V4 to V6) may be covered by a conductive pad (e.g., the third pad 330). In this way, the ninth via V9 may not directly contact the first board 150 or the second board 190. Referring to FIG. 11A, when viewed in a lengthwise direction (e.g., the z axis direction) of the via, the fourth via V4, the fifth via V5, and the sixth via V6 may at least partially overlap the pad that defines a portion of the surface of the interposer 200. Referring to FIG. 11A, when viewed in the lengthwise direction (e.g., the z axis direction) of the via, the ninth via V9 may not overlap the conductive pad that defines a portion of the surface (e.g., the first surface 201 or the second surface 202) of the interposer 200 but may overlap the cover layers 230a and 230b. When viewed in the lengthwise direction (e.g., the z axis direction) of the via, the ninth via V9 may at least partially overlap the third conductive pattern 223. The ninth via V9 may at least partially contact the third conductive pattern 223. In an embodiment, the first insulation area 231 may be located between the second area 332 included in the 2a-th structure 302a and the first area 331 included in the 2b-th structure 302b. Accordingly, the 2a-th structure 302a and the 2b-th structure 302b may not be connected to each other through a pad, but may be connected to each other through the third conductive pattern 223 included in the conductive layers 220a and 220bn in the interiors thereof.

In an embodiment, the ninth via V9 may be electrically connected to the fourth via V4 included in the 2b-th structure 302b and the fifth via V5 included in the 2a-th structure 302a, by the third conductive pattern 223. Referring to FIG. 11A, the ninth via V9 may be located between the 2a-th structure 302a and the 2b-th structure 302b that are spaced apart from each other to form a denser shielding wall and provide an enhanced shielding performance.

In an embodiment, like the ninth via V9, the third conductive pattern 223 may be covered by the first insulation areas 231 of the cover layers 230a and 230b. The third conductive pattern 223 may be disposed between the insulation layer 210 and the cover layers 230a and 230b, and may extend along the extension direction "E" of the interposer 200. The third conductive pattern 223 may extend from the fourth via V4 included in the 2b-th structure 302b to the fifth via V5 included in the 2a-th structure 302a via the ninth via V9. For example, the third conductive pattern 223 may not be exposed to the surface (e.g., the first surface 201 or the second surface 202) of the interposer 200.

In an embodiment, because the third conductive pattern 223 is covered by the first insulation areas 231 of the cover layers 230a and 230b, the mounting areas of the first board 150 and the second board 190 may be efficiently utilized. For example, it is not necessary to dispose a ground pad in areas of the first board 150 and the second board 190, which face the third conductive pattern 223, and a pattern, in which not a ground signal but another signal flows, may be disposed in the areas. For example, the signal line may be electrically insulated from the third conductive pattern 223 by the cover layers 230a and 230b.

Referring to FIGS. 10 and 11B, the first part P1 may further include a tenth via V10, an eleventh via V11, and a fourth pad 340 that are spaced apart from the fourth structure 304. In various embodiments, the tenth via V10 and the fourth pad 340 may be referenced as the third via V3 of FIG. 7B and the second pad 320. For example, the fourth pad 340 may have an area that is larger than that of the tenth via hole to contact an end of the tenth via V10 in the z axis direction and fully cover the end of the tenth via V10. In an embodiment, a second insulation area 232 may be located between the fourth pad 340, and the second area 332 of the 2b-th structure 302b that is adjacent to the fourth pad 340.

Referring to FIG. 11B, the tenth via V10 ma be electrically connected to the via (e.g., the fifth via V5 of the 2b-th structure 302b) of the fourth structure 304 by a fourth conductive pattern 224. The fourth conductive pattern 224 may be included in the conductive layers 220a and 220b, and may be covered by the second insulation areas 232 of the cover layers 230a and 230b not to be exposed to the surface (e.g., the first surface 201 or the second surface 202) of the interposer 200.

Referring to FIG. 11B, the eleventh via V11 may be located between the tenth via V10 and the via (e.g., the fifth via V5 of the 2b-th structure 302b) that is adjacent to the fourth structure 304. The eleventh via V11 may be disposed to at least partially overlap the fourth conductive pattern 224 and contact the fourth conductive pattern 224. Because the eleventh via V11 is located between the tenth via V10 and the fifth via V5, the interposer 200 may provide a denser shielding wall.

Referring to FIG. 11B, because the fourth conductive pattern 224 and the eleventh via V11 are covered by the cover layers 230a and 230b, the mounting areas of the first board 150 and the second board 190 may be efficiently utilized. For example, it is not necessary to dispose a ground pad in areas of the first board 150 and the second board 190, which face the fourth conductive pattern 224, and a pattern, in which another signal flows, may be disposed in the areas. For example, the signal line may be electrically insulated from the fourth conductive pattern 224 and the eleventh via V11 by the cover layers 230a and 230b.

Referring to FIG. 10, the interval d2 between the vias included in the first part P1 may be smaller than or equal to the interval d1 between the vias (e.g., the signal vias) included in the second part P2. For example, because the vias included in the first part P1 are all ground vias, they may be connected to each other by one pad, or may be connected to each other by the third conductive pattern 223 and/or the fourth conductive pattern 224 included in the conductive layers 220a and 220b. Accordingly, the vias included in the first part P1 may be located closer to each other than the vias included in the second part P2. In various embodiments, the vias included in the second part P2 are spaced apart from each other by a distance of 0.5 mm to 0.8 mm, and the vias included in the first part P1 may be spaced apart from each other by a distance of 0.2 mm or less. In various embodiments, the third distance d3, the fourth distance d4, the fifth distance d5, the sixth distance d6, and the width "w" illustrated in FIG. 8 may be defined in the interposer 200 illustrated in FIG. 10 in substantially the same way.

According to an embodiment, the first part P1 of the interposer 200 may include various forms of shielding structures 301, 302, 303, and 304 including the one or more ground vias. The one or more ground vias may be electrically connected to each other through the pad (e.g., the first pad 310 or the third pad 330) formed on the surface of the interposer 200, or the conductive layers 220a and 220b located under the cover layers 230a and 230b. For example, when the ground vias or the shielding structures 301, 302, 303, and 304 are connected to each other through the pad (e.g., the first pad 310 or the third pad 330), contact areas between the interposer 200 and the boards 150 and 190 are increased to provide firm coupling. For example, when the ground vias or the shielding structures 301, 302, 303, and 304 are connected to each other through the conductive layers 220a and 220b, the mounting areas of the boards 150 and 190 may be efficiently utilized. Furthermore, because the ground vias has no danger of a short-circuit unlike the signal vias, they are disposed at a denser distance than the signal vias, and thus this may provide an enhanced shielding performance. The dense distance of the ground vias may provide a shielding performance, by which the plating area provided on the side surface of the interposer 200 of the comparative embodiment may be replaced.

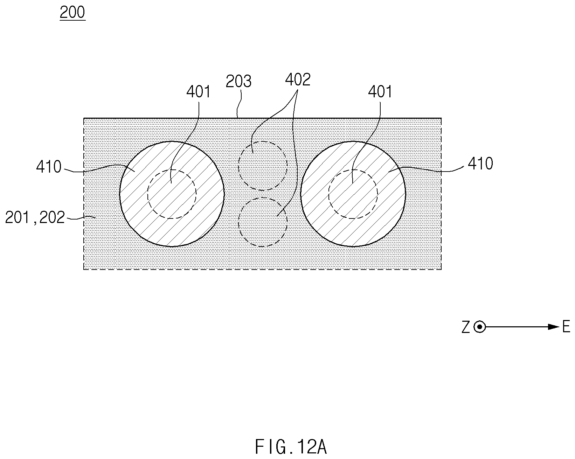

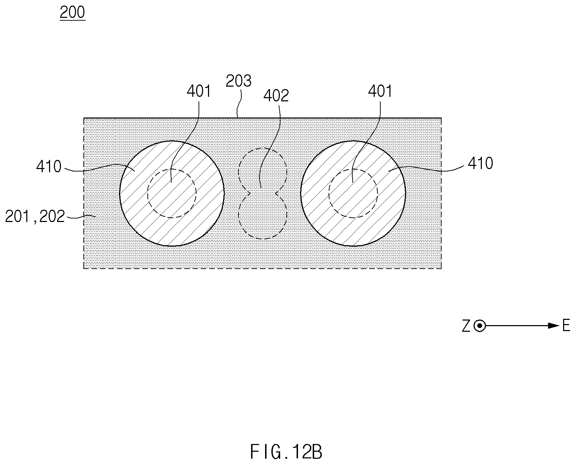

FIG. 12A is a view illustrating a portion of a surface of a first part of an interposer according to various embodiments. FIG. 12B is a view illustrating a portion of a surface of a first part of an interposer according to various embodiments.

Referring to FIGS. 12A and 12B, the first part of the interposer 200 may include first vias 401 and second vias 402, to which a ground signal is applied. The first vias 401 and the second vias 402 may extend long in the z axis direction.

In an embodiment, when viewed in the z axis direction, the first vias 401 may be defined as the vias that fully overlap the conductive first pad 410. For example, the first pad 410 may be located in each of the first vias 401 in the z axis direction. For example, the first pad 410 may be a pad that has a substantially circular or arc-shaped periphery.

In an embodiment, when viewed in the z axis direction, the second vias 402 may be defined as vias that are covered by the insulating cover layers not to be exposed to an outside. For example, the cover layers (e.g., the cover layers 230a and 230b of FIG. 11A) may be located in each of the second vias 402 in the z axis direction.

In an embodiment, the first vias 401 may be surface-mounted on the first board 150 or the second board 190 through the first pad 410. For example, the first vias 401 may be electrically connected to the ground area of the first board 150 or the second board 190 through the first pad 410. In an embodiment, the first pad 410 may be connected to the first board 150 or the second board 190 by a solder ball, a solder wall, and/or a solder resin. In an embodiment, the solder wall and the solder ball may be formed of the same material. For example, the solder wall and/or the solder ball may include at least one of tin, lead, silver, copper, and zinc.

In an embodiment, when viewed in the extension direction "E" of the interposer 200, the second vias 402 may be located between the first vias 401. Referring to FIG. 12A, the second vias 402 may include two or more vias. In an embodiment, the second vias 402 may be electrically connected to the first vias 401 through the conductive pattern (e.g., the third conductive pattern 223 of FIG. 11A) included in the conductive layer (e.g., the conductive layers 220a and 220b of FIG. 11A) located below the cover layer (e.g., the cover layers 230a and 230b of FIG. 11A). For example, the second vias 402 may be electrically insulated from a circuit of the first board 150 or the second board 190 by the cover layer (e.g., the cover layers 230a and 230b of FIG. 11A).

In various embodiments, referring to FIG. 12B, the second vias 402 may be configured such that two vias at least partially overlap each other. For example, the second via 402 of FIG. 12B may include one communicated via hole, and a conductive material filled in the via hole. The via hole may have an 8 shape. In various embodiments, referring to FIG. 12B, the second via 402 may have a shape that is longer in a widthwise direction that is substantially perpendicular to the extension direction "E", than in the extension direction "E". For example, the second via 402 may be configured such that two second via holes partially overlap each other in the widthwise direction.

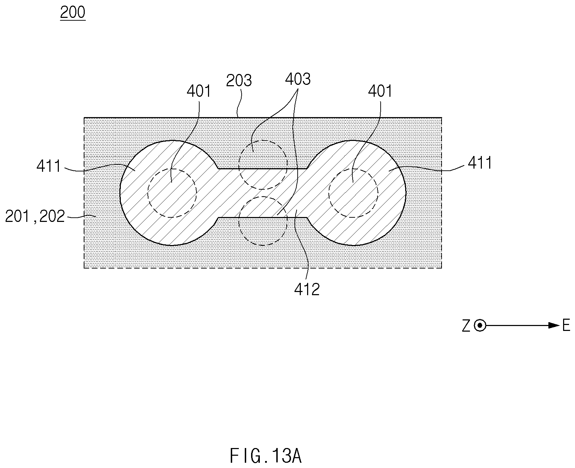

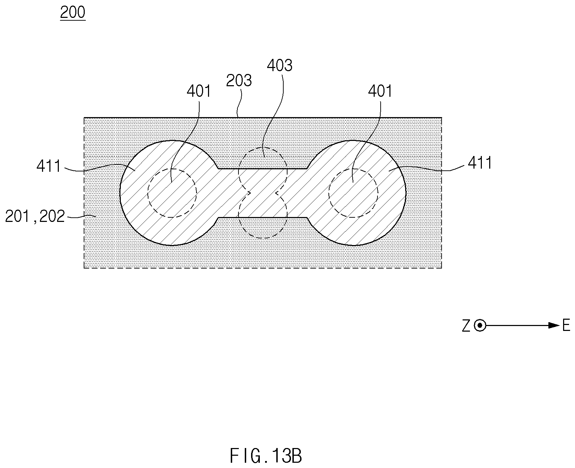

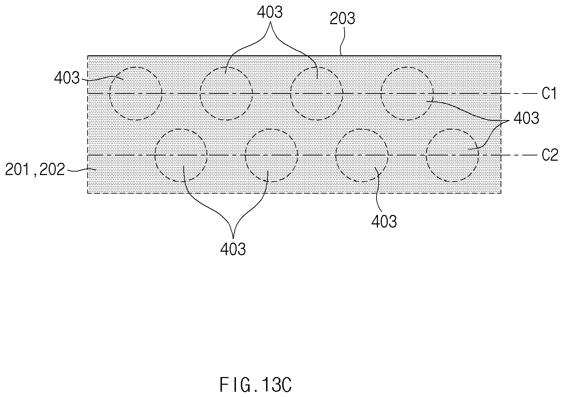

FIG. 13A is a view illustrating a portion of a surface of a first part of an interposer according to various embodiments. FIG. 13B is a view illustrating a portion of a surface of a first part of an interposer according to various embodiments. FIG. 13C is a view illustrating a portion of a surface of a first part of an interposer according to various embodiments.

Referring to FIGS. 13A and 13B, the first part of the interposer 200 may include first pads 411 and 412 that are formed on the first vias 401, to which a ground signal is applied, the third via 403m, and the surface of the interposer 200, and at least partially cover the first vias 401 and the third via 403. The first vias 401 and the third vias 403 may extend long in the z axis direction.

FIGS. 13A and 13B may be modifications of the second structure 302 illustrated in FIG. 8. For example, the first vias 401 may be referenced by the fourth via V4 and the fifth via V5 of FIG. 8. The first pads 411 and 412 may be referenced by the third pad 330 of FIG. 8.

In an embodiment, when viewed in the z axis direction, the first vias 401 may be defined as the vias that fully overlap the conductive first pads 411 and 412. For example, the first vias 401 may have a substantially circular or arc-shaped periphery in the z axis direction, and the first areas 411 of the conductive first pads 411 and 412 may be located in the first vias 401.

In an embodiment, when viewed in the z axis direction, the third via 403 may be defined as a via that at least partially overlaps the cover layer (e.g., the cover layers 230a and 230b of FIG. 9A). For example, a partial area of the third via 403 may overlap the second areas 412 of the conductive first pads 411 and 412, and other partial areas thereof may overlap the insulating cover layers 230a and 230b.

In an embodiment, the first area 411 and the second area 412 of the first pads 411 and 412 may be surface-mounted on the first board 150 or the second board 190, and may be electrically connected to the ground area of the first board 150 or the second board 190. In an embodiment, the first pads 411 and 412 may be connected to the first board 150 or the second board 190 by a solder ball, a solder wall, and/or a solder resin. In an embodiment, the solder wall and the solder ball may be formed of the same material. For example, the solder wall and/or the solder ball may include at least one of tin, lead, silver, copper, and zinc.

In an embodiment, when viewed in the extension direction "E" of the interposer 200, the third vias 403 may be located between the first vias 401. The third vias 403 may at least partially contact the second areas 412 of the first pads 411 and 412. Referring to FIG. 13A, the third vias 403 may include two or more vias. In an embodiment, the third vias 403 may be electrically connected to the first vias 401 through the conductive pattern included in the conductive layer (e.g., the conductive layers 220a and 220b of FIG. 9A) located below the cover layer (e.g., the cover layers 230a and 230b of FIG. 9A), and/or the second area 412 of the first pad 411 and 412.

In various embodiments, referring to FIG. 13B, the third vias 403 may be configured such that two vias at least partially overlap each other. For example, the third via 403 of FIG. 13B may include one communicated via hole, and a conductive material filled in the via hole. The via hole may have an 8 shape. In various embodiments, referring to FIG. 13B, the third via 403 may have a shape that is longer in a widthwise direction that is substantially perpendicular to the extension direction "E", as in the extension direction "E". For example, the third via 403 may be configured such that two third via holes partially overlap each other in the widthwise direction. Referring to FIG. 13C, the first part of the interposer 200 may be configured such that the third vias 403 are arranged in at least two columns C1 and C2. The first column C1 may be defined as a column that is closest to the outer surface 203, and the second column C2 may be defined as a column that is closest to the first column C1. The third vias 403 may be ground vias that are electrically connected to each other through the conductive layers (e.g., the conductive layers 220a and 220b of FIG. 11A). The third vias 403 may not be directly connected to the pads (e.g., the first pads 411 and 412) formed on the surfaces 201 and 202 of the interposer 200. For example, the third vias 403 may overlap the cover layers (e.g., the cover layers 230a and 230b of FIG. 11A) in the z axis direction. In various embodiments, because the third vias 403 are not directly connected to the pads, there is no short-circuit problem, whereby they may be disposed at a denser distance than the first vias 401 or the second vias 402. Through this, the shielding performance of the interposer 200 may be further enhanced.

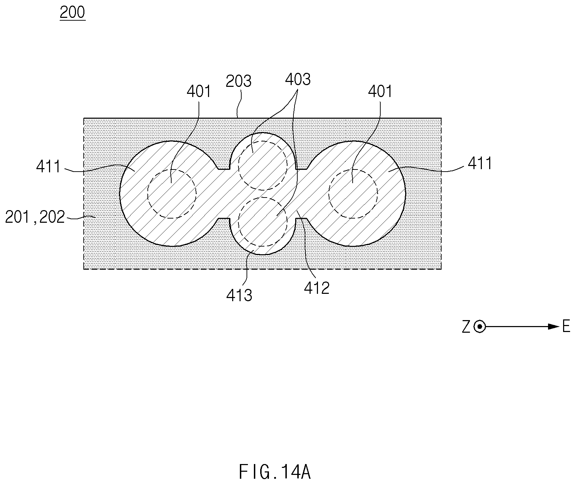

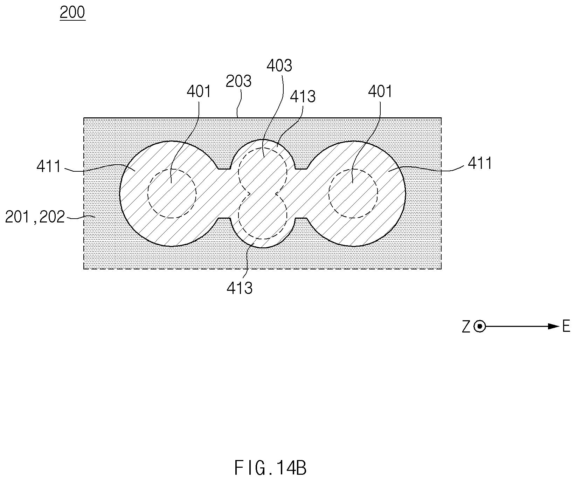

FIG. 14A is a view illustrating a portion of a surface of a first part of an interposer according to various embodiments. FIG. 14B is a view illustrating a portion of a surface of a first part of an interposer according to various embodiments.

It may be understood that the interposer illustrated in FIG. 14A is one obtained by adding a third area 413 to the interposer 200 illustrated in FIG. 13A. It may be understood that the interposer 200 illustrated in FIG. 14B is obtained by adding the third area 413 to the interposer 200 illustrated in FIG. 13B. In a description of FIGS. 14A and 14B, a description of the same contents as those described in FIGS. 13A and 13B may be omitted.

Referring to FIGS. 14A and 14B, the first pads 411, 412, and 413 may further include the third area 413. The third area 413 may be configured to overlap the third via 403 when viewed in the z axis direction. A periphery of the third area 413 may have a partially circular or elliptical shape. The third area 413 may extend from the second area 412 and/or the first area 411. As the interposer 200 further includes the third area 413, contact areas with the boards 150 and 190 may increase and thus firm coupling of the interposer 200 and the boards 150 and 190 may be provided.

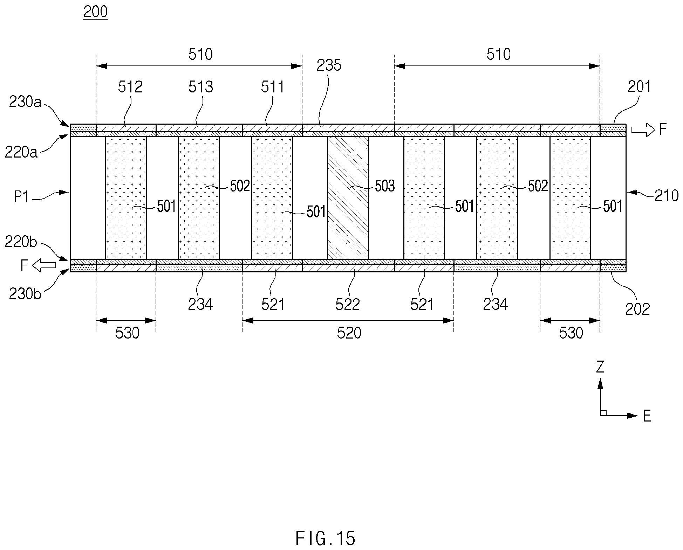

FIG. 15 is a view illustrating an interposer according to various embodiments.

In an embodiment, the first part P1 of the interposer 200 may include a plurality of ground vias 501, 502, and 503. The interposer 200 may be configured such that the first surface 201 thereof contacts the second board 190, and the second surface 202 thereof contacts the first board 150. The ground vias 501, 502, and 503 may electrically connect the ground areas of the first board 150 and the second board 190, through conductive pads 510 formed on the first surface 201 and conductive pads 520 and 530 formed on the second surface 202. The plurality of ground vias 501, 502, and 503 may be electrically connected to each other through the conductive layers 220a and 220b or the conductive pads 510, 520, and 530. In an embodiment, the conductive pad 510 formed on the first surface 201 and the conductive pads 520 and 530 formed on the second surface 202 may be configured to at least partially face each other when viewed in the z axis direction (e.g., a lengthwise direction of the vias).

For example, the first conductive pad 510 may be formed on the first surface 201 of the interposer 200, and the second conductive pad 520 and the third conductive pad 530 may be formed on the second surface 202. Referring to FIG. 15, when viewed in the z axis direction, the first area 511 of the first conductive pad 510 may face the first area 521 of the second conductive pad 520, the second area 512 of the first conductive pad 510 may face the third conductive pad 530, and the third area 513 of the first conductive pad 510 may face the insulation area 234 formed in the second cover layer 230b. Referring to FIG. 15, the first area 521 of the second conductive area 520 may face the first area 511 of the first conductive pad 510, and the second area 522 of the second conductive pad 520 may face the insulation area 235 formed in the first cover layer 230a.

For example, referring to FIGS. 6 to 11, the pad located on the first surface 201 and the pad located on the second surface 202 may be provided at substantially the same location. Meanwhile, referring to FIG. 15, the conductive pad 510 provided on the first surface 201 and the conductive pads 520 and 530 provided on the second surface 202 may be formed to be misaligned such that some areas thereof face each other and other areas thereof do not face each other. Accordingly, coupling areas of the interposer 200, and the first board 150 and the second board 190 may be configured to be partially misaligned. The coupling structure may enhance coupling forces of the interposer 200 and the boards 150 and 190. For example, when stresses (e.g., shear stresses F) in opposite directions, which are applied to the first board 150 and the second board 190 in the extension direction "E", is applied, an effect that is similar to an effect of substantially increasing the contact areas may be achieved by the conductive pads that are disposed to be misaligned.

In various embodiments, the first part P1 of the interposer 200 may include the ground vias 501, 502, and 503, and when viewed in the first direction (e.g., the z axis direction), the ground vias may include the first via 501 located between the conductive pad of the first surface 201 and the conductive pad of the second surface 202, the second via 502 located between the conductive pad of the first surface 501 and the insulation area 234 of the second surface 202, and the third via 503 located between the insulation area 235 of the first surface 201 and the conductive pad of the second surface 202. In various embodiments, referring to FIG. 11A, the vias may include the ninth via V9 located between the insulation area (e.g., the first insulation area 231 of FIG. 11A) of the first surface 201 and the insulation area (e.g., the second insulation area 232 of FIG. 11A) of the second surface 202.

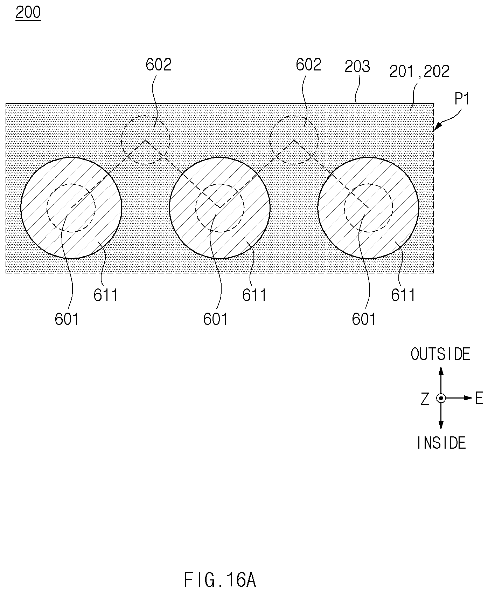

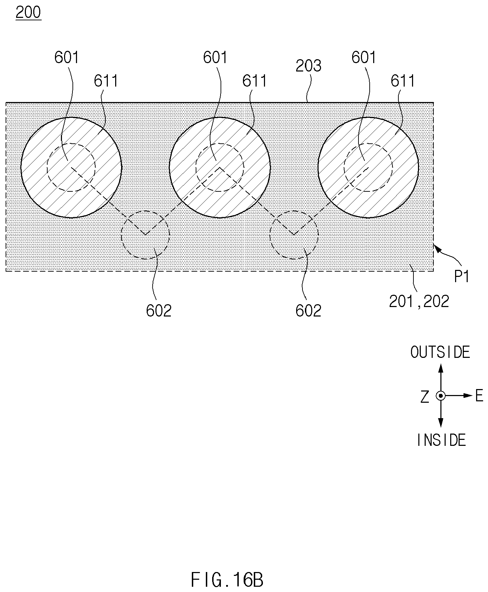

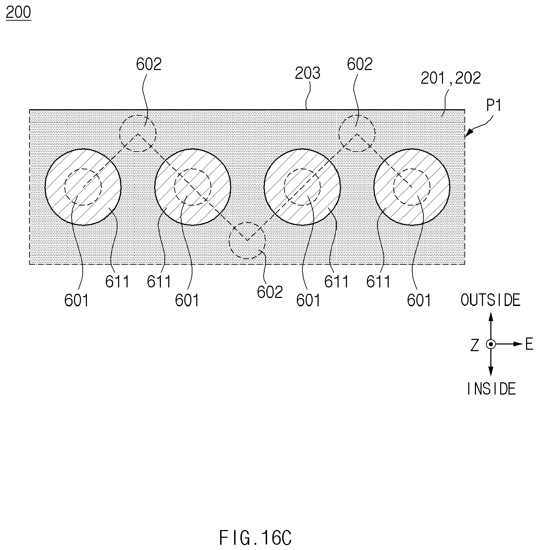

FIGS. 16A, 16B, and 16C are views illustrating disposition of ground vias according to various embodiments.

Referring to FIGS. 16A, 16B, and 16C, the first part P1 of the interposer 200 may include ground vias 601 and 602. The ground vias 601 and 602 may include first vias 601 and second vias 602. The first vias 601 may be defined as vias that are directly connected to pads 611 located on the surfaces 201 and 202 of the interposer 200. For example, when the surfaces 201 and 202 of the interposer 200 are viewed from a top, the first vias 601 may overlap the pads 611. The second vias 602 may be defined as vias that overlap the covers (e.g., the cover layers 230a and 230b of FIG. 15) on the surfaces 201 and 202 of the interposer 200. The first vias 601 may provide a physical/electrical connection for the interposer 200 and the boards 150 and 190 through the pads 611, and the second vias 602 may be disposed in spaces between the vias 601 to enhance the shielding performance. The first vias 601 and the second vias 602 may be electrically connected to each other through the conductive patterns included in the conductive layers.

In various embodiments, the second vias 602 may be referenced by the ninth via V9 of FIG. 11A, or the second via 502 of the third via 503 of FIG. 15.

Referring to FIGS. 16A, 16B, and 16C, the first vias 601 and the second vias 602 may be disposed in a zigzag form. For example, the first vias 601 may be arranged in the extension direction "E", and the second vias 602 may be arranged in the extension direction "E" and may be disposed inside or outside the first vias 601. In a description of the drawings, a direction that faces the outer surface 203 and is substantially perpendicular to the extension direction "E" is defined as an outward direction, and an opposite direction thereto is defined as an inward direction.

Referring to FIG. 16A, the first vias 601 and the second vias 602 may be arranged in the extension direction "E". When viewed in the extension direction "E", the second vias 602 may be located between the first vias 601, and may be disposed closer to the outer surface 203 than the first vias 601.

Referring to FIG. 16B, the first vias 601 and the second vias 602 may be arranged in the extension direction "E". When viewed in the extension direction "E", the second vias 602 may be located between the first vias 601, and may be disposed closer to the inward direction than the first vias 601.

Referring to FIG. 16C, the first vias 601 may be arranged in the extension direction "E", and the second vias 602 may be located between the first vias 601 and be disposed in the inward direction or the outward direction with respect to the first vias 601 when viewed in the extension direction "E". For example, any one second via may be located on an outer side of the adjacent two first vias 601, and the other second via that is adjacent to the any one second via may be located on an inner side of the adjacent two first vias 601.

According to an embodiment of the disclosure, the one or more vias V1 to V9, 401, 402, 403, 501, 502, and 503 illustrated in FIGS. 6 to 16 may be conductive holes that are punched for electrical connection for different boards (e.g., the first board 150 and the second board 190). The one or more vias, for example, may include plated through holes (PTHs).

The interposer 200 according to embodiments described in the disclosure may provide a sufficient shielding performance without any side plating area, unlike the interposer of the comparative embodiment, as the plurality of ground vias are intensively disposed in the first part and the ground vias are connected to each other in various forms. Furthermore, a plating process that requires relatively high costs may be omitted, and thus product costs of the interposer may be remarkably reduced.

FIG. 17 is a block diagram illustrating an electronic device in a network environment according to an embodiment of the disclosure.

Referring to FIG. 17, an electronic device 1701 in a network environment 1700 may communicate with an electronic device 1702 via a first network 1798 (e.g., a short-range wireless communication network), or an electronic device 1704 or a server 1708 via a second network 1799 (e.g., a long-range wireless communication network). According to an embodiment, the electronic device 1701 may communicate with the electronic device 1704 via the server 1708. According to an embodiment, the electronic device 1701 may include a processor 1720, memory 1730, an input device 1750, a sound output device 1755, a display device 1760, an audio module 170, a sensor module 1776, an interface 177, a haptic module 1779, a camera module 1780, a power management module 1788, a battery 1789, a communication module 1790, a subscriber identification module (SIM) 1796, or an antenna module 1797. In some embodiments, at least one (e.g., the display device 1760 or the camera module 1780) of the components may be omitted from the electronic device 1701, or one or more other components may be added in the electronic device 1701. In some embodiments, some of the components may be implemented as single integrated circuitry. For example, the sensor module 1776 (e.g., a fingerprint sensor, an iris sensor, or an illuminance sensor) may be implemented as embedded in the display device 1760 (e.g., a display).

The processor 1720 may execute, for example, software (e.g., a program 1740) to control at least one other component (e.g., a hardware or software component) of the electronic device 1701 coupled with the processor 1720, and may perform various data processing or computation. According to an embodiment, as at least part of the data processing or computation, the processor 1720 may load a command or data received from another component (e.g., the sensor module 1776 or the communication module 1790) in volatile memory 1732, process the command or the data stored in the volatile memory 1732, and store resulting data in non-volatile memory 1734. According to an embodiment, the processor 1720 may include a main processor 1721 (e.g., a central processing unit (CPU) or an application processor (AP)), and an auxiliary processor 1723 (e.g., a graphics processing unit (GPU), an image signal processor (ISP), a sensor hub processor, or a communication processor (CP)) that is operable independently from, or in conjunction with, the main processor 1721. Additionally or alternatively, the auxiliary processor 1723 may be adapted to consume less power than the main processor 1721, or to be specific to a specified function. The auxiliary processor 1723 may be implemented as separate from, or as part of the main processor 1721.

The auxiliary processor 1723 may control at least some of functions or states related to at least one component (e.g., the display device 1760, the sensor module 1776, or the communication module 1790) among the components of the electronic device 1701 , instead of the main processor 1721 while the main processor 1721 is in an inactive (e.g., sleep) state, or together with the main processor 1721 while the main processor 1721 is in an active state (e.g., executing an application). According to an embodiment, the auxiliary processor 1723(e.g., an image signal processor or a communication processor) may be implemented as part of another component (e.g., the camera module 1780 or the communication module 1790) functionally related to the auxiliary processor 1723.

The memory 1730 may store various data used by at least one component (e.g., the processor 1720 or the sensor module 1776) of the electronic device 1701. The various data includes, for example, software (e.g., the program 1740) and input data or output data for a command related thereto. The memory 1730 may include the volatile memory 1732 or the non-volatile memory 1734. The non-volatile memory 1734 may include an internal memory 1736 or external memory 1738.

The program 1740 may be stored in the memory 1730 as software, and includes, for example, an operating system (OS) 1742, middleware 1744, or an application 1746.

The input device 1750 may receive a command or data to be used by other components (e.g., the processor 1720) of the electronic device 1701, from the outside (e.g., a user) of the electronic device 1701. The input device 1750 includes, for example, a microphone, a mouse, a keyboard, or a digital pen (e.g., a stylus pen).

The sound output device 1755 may output sound signals to the outside of the electronic device 1701. The sound output device 1755 includes, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 1760 may visually provide information to the outside (e.g., a user) of the electronic device 1701. The display device 1760 includes, for example, a display, a hologram device, or a projector and control circuitry to control a corresponding one of the display, hologram device, and projector. According to an embodiment, the display device 1760 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 1750, or output the sound via the sound output device 1755 or a headphone of an external electronic device (e.g., an electronic device 1702) directly (e.g., wiredly) or wirelessly coupled with the electronic device 1701.

The sensor module 1776 may detect an operational state (e.g., power or temperature) of the electronic device 1701 or an environmental state (e.g., a state of a user) external to the electronic device 1701, and then generate an electrical signal or data value corresponding to the detected state. According to an embodiment, the sensor module 1776 includes, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1777 may support one or more specified protocols to be used for the electronic device 1701 to be coupled with the external electronic device (e.g., the electronic device 1702) directly (e.g., wiredly) or wirelessly. According to an embodiment, the interface 1777 includes, for example, a high definition multimedia interface (HDMI), a universal serial bus (USB) interface, a secure digital (SD) card interface, or an audio interface.

A connecting terminal 1778 may include a connector via which the electronic device 1701 may be physically connected with the external electronic device (e.g., the electronic device 1702). According to an embodiment, the connecting terminal 1778 includes, for example, an HDMI connector, a USB connector, an SD card connector, or an audio connector (e.g., a headphone connector).

The haptic module 1779 may convert an electrical signal into a mechanical stimulus (e.g., a vibration or a movement) or electrical stimulus which may be recognized by a user via his tactile sensation or kinesthetic sensation. According to an embodiment, the haptic module 1779 includes, for example, a motor, a piezoelectric element, or an electric stimulator.

The camera module 1780 may capture a still image or moving images. According to an embodiment, the camera module 1780 may include one or more lenses, image sensors, image signal processors, or flashes.

The power management module 1788 may manage power supplied to the electronic device 1701. According to an embodiment, the power management module 1788 may be implemented as at least part of, for example, a power management integrated circuit (PMIC).

The battery 1789 may supply power to at least one component of the electronic device 1701. According to an embodiment, the battery 1789 includes, for example, a primary cell which is not rechargeable, a secondary cell which is rechargeable, or a fuel cell.

The communication module 1790 may support establishing a direct (e.g., wired) communication channel or a wireless communication channel between the electronic device 1701 and the external electronic device (e.g., the electronic device 1702, the electronic device 1704, or the server 1708) and performing communication via the established communication channel. The communication module 1790 may include one or more communication processors that are operable independently from the processor 1720 (e.g., the application processor (AP)) and supports a direct (e.g., wired) communication or a wireless communication. According to an embodiment, the communication module 1790 may include a wireless communication module 1792 (e.g., a cellular communication module, a short-range wireless communication module, or a global navigation satellite system (GNSS) communication module) or a wired communication module 1794 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 1799 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1792 may identify and authenticate the electronic device 1701 in a communication network, such as the first network 198 or the second network 1799, using subscriber information (e.g., international mobile subscriber identity (IMSI)) stored in the subscriber identification module 196.

The wireless communication module 1792 may support a fifth generation (5G) network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1792 may support a high-frequency band (e.g., the millimeter wave (mmWave band)) to achieve, e.g., a high data transmission rate. The wireless communication module 1792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1792 may support various requirements specified in the electronic device 1701, an external electronic device (e.g., the electronic device 1704), or a network system (e.g., the second network 1799). According to an embodiment, the wireless communication module 1792 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1797 may transmit or receive a signal or power to or from the outside (e.g., the external electronic device) of the electronic device 1701. According to an embodiment, the antenna module 1797 may include an antenna including a radiating element implemented using a conductive material or a conductive pattern formed in or on a substrate (e.g., PCB). According to an embodiment, the antenna module 1797 may include a plurality of antennas. In such a case, at least one antenna appropriate for a communication scheme used in the communication network, such as the first network 198 or the second network 1799, may be selected, for example, by the communication module 1790 (e.g., the wireless communication module 1792) from the plurality of antennas. The signal or the power may then be transmitted or received between the communication module 1790 and the external electronic device via the selected at least one antenna. According to an embodiment, another component (e.g., a radio frequency integrated circuit (RFIC)) other than the radiating element may be additionally formed as part of the antenna module 1797.

According to certain embodiments, the antenna module 1797 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1701 and the external electronic device 1704 via the server 1708 coupled with the second network 1799. Each of the electronic devices 1702 and 1704 may be a device of a same type as, or a different type, from the electronic device 1701. According to an embodiment, all or some of operations to be executed at the electronic device 1701 may be executed at one or more of the external electronic devices 1702 or 1704, or the server 1708. For example, if the electronic device 1701 should perform a function or a service automatically, or in response to a request from a user or another device, the electronic device 1701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1701. The electronic device 1701 may provide the outcome, with or without further processing of the outcome, as at least part of a reply to the request. To that end, a cloud computing, distributed computing, or client-server computing technology may be used, for example. The electronic device 1701 may provide ultra-low-latency services using, e.g., distributed computing or mobile edge computing. In another embodiment, the external electronic device 1704 may include an internet-of-things (IoT) device. The server 1708 may be an intelligent server using machine learning and/or a neural network. According to an embodiment, the external electronic device 1704 or the server 1708 may be included in the second network 1799. The electronic device 1701 may be applied to intelligent services (e.g., smart home, smart city, smart car, or healthcare) based on 5G communication technology or IoT-related technology.

An electronic device according to embodiment disclosed in the disclosure may include the housing 110, the first board 150 and the second board 190 disposed in the interior of the housing 110 and disposed to face each other in a first direction (the z axis direction), and the interposer 200 extending to surround the interior space 209 between the first board 150 and the second board 190, electrically connecting the first board 150 and the second board 190, and including vias extending in the first direction, wherein the interposer 200 includes the first part P1 defining the outer surface 203 thereof, and the second part P2 defining the inner surface 204 thereof, which faces the interior space, and surrounded by the first part P1, and wherein the first part P1 shields the second part P2 and the interior space 209, the vias included in the first part P1 may be all ground vias and be spaced apart from each other by a first distance, and the vias included in the second part P2 may include signal vias and ground vias, the number of which is smaller than that of the signal vias, and are spaced apart from each other by a second distance that is larger than or equal to the first distance.

In various embodiments, the first part P1 may include the first vias V1 and V4, the second vias V2 and V5 spaced apart from the first vias V1 and V4 in the extension direction "E" of the interposer 200, and the first pads 310 and 330 connected to the first vias V1 and V4 and the second vias V2 and V5, and when viewed in the first direction, the first pads 310 and 330 may include the first areas 311 and 331 covering an end of the first vias V1 and V4, the second areas 312 and 332 covering an end of the second vias V2 and V5, and the third areas 313 and 333 connecting the first areas 311 and 331 and the second areas 312 and 332.

In various embodiments, the first pads 310 may be formed on the first surface 201 and the second surface 202 of the interposer 200, respectively, to be mounted on the first board 150 and the second board 190.

In various embodiments, the first part P1 may further include the third via V6 located between the first via V4 and the second via V5 and connected to the third area 333, and when viewed in the first direction, the third via V6 may at least partially overlap the third area 333.

In various embodiments, the first areas 311 and 331 may have a substantially circular or arc-shaped periphery, and have an area that is larger than a size of the first via hole of the first vias V1 and V4, and the second areas 312 and 332 may have a substantially circular or arc-shaped periphery, and have an area that is larger than a size of the second via hole of the second vias V2 and V5.

In various embodiments, a width of the third areas 313 and 333 may be smaller than a maximum width of the first areas 311 and 331 or the second area 312 and 332, and the width may be defined as a distance measured in a direction that is perpendicular to the extension direction "E" of the interposer 200.

In various embodiments, the first part P1 may include the fourth via V10 spaced apart from the second via V5, and the second pad 340 connected to the fourth via V10, the insulation area 232 of the cover layer 230 may be formed between the second pad 340 and the second area 332 of the first pad 330, and the fourth via V10 and the second via V5 may be electrically connected to each other through a conductive pattern 224 disposed under the insulation area 232.

In various embodiments, the first part P1 may further include the fifth via V11 located between the fourth via V10 and the second via V5 and at least partially contacting the conductive pattern 224, and when the interposer 200 is viewed in the first direction, the fifth via V11 may be covered by the insulation area 231.

In various embodiments, the first board 150 or the second board 190 may include a first mounting area facing the first pads 310 and 330 and the second pad 340 of the interposer 200, and a second mounting area facing the insulation areas 231 and 232 of the interposer 200, the first mounting area may be a ground area, and the second mounting area may include a pattern, through which a signal that is not a ground signal flows.

In various embodiments, the third via V6 may include two or more third vias 402 and 403 disposed in the widthwise direction "W" that is perpendicular to the extension direction "E" of the interposer 200.

In various embodiments, the third vias 402 and 403 may be formed longer in a widthwise direction that is perpendicular to the extension direction than in the extension direction, and a third via hole of the third via may have a form, in which two via holes partially overlap each other.

In various embodiments, the fifth via V11 may include two or more fifth vias 402 and 403 disposed in the widthwise direction "W" that is perpendicular to the extension direction "E" of the interposer.

In various embodiments, the fifth vias 402 and 403 may be formed longer in a widthwise direction that is perpendicular to the extension direction than in the extension direction, and a fifth via hole of the fifth via may have a form, in which two via holes partially overlap each other.

In various embodiments, the first distance may be 0.2 mm or less, and the second distance may be 0.5 mm to 0.8 mm.

In various embodiments, when the interposer is viewed in the first direction, an area occupied by the first part may be smaller than an area occupied by the second part.

In various embodiments, the number of the vias included in the first part may be smaller than the number of the vias included in the second part.

In various embodiments, the interposer 200 may include the first surface 201 contacting the first board 150, and the second surface 202 contacting the second board 190, the first surface may include the first conductive pad 510 coupled to the first board, and the first insulation area 235 surrounding the first conductive pad, the second surface may include the second conductive pads 520 and 530 coupled to the second board, and the second insulation area 234 surrounding the second conductive pad, and when viewed in the first direction, the vias included in the first part "P1" may include the first via 501 located between the first conductive pad 510 and the second conductive pad, the second via 502 located between the first conductive pad 510 and the second insulation area 234, the third via 503 located between the first insulation area 235 and the second conductive pad 522, and the fourth vias V9 and V11 located between the first insulation area 235 and the second insulation area 234.

In various embodiments, when viewed in the first direction, the first area of the first conductive pad 510 partially may face the second conductive pad 520, and when viewed in the first direction, the second area of the first conductive pad 510 partially may face the second insulation area 234.

In various embodiments, the first board may include a first conductive area soldered to the first conductive pad, the second board may include a second conductive area soldered to the second conductive pad, and when viewed in the first direction, the first conductive area and the second conductive area at least partially misaligned.

In various embodiments, the interposer 200 may include the insulating cover layer 230 defining the surfaces 201 and 202 of the interposer 200, and the conductive layer 220 disposed under the cover layer, and the conductive layer may include a conductive pattern extending to correspond to the first part P1, and connected to the vias included in the first part P1.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1740) including one or more instructions that are stored in a storage medium (e.g., internal memory 1736 or external memory 1738) that is readable by a machine (e.g., the electronic device 1701). For example, a processor (e.g., the processor 1720) of the machine (e.g., the electronic device 1701) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing;
a first board and a second board disposed in an interior of the housing and disposed to face each other in a first direction; and
an interposer extending to surround an interior space between the first board and the second board, electrically connecting the first board and the second board, and including vias extending in the first direction, wherein the interposer includes a first part defining an outer surface thereof, and a second part defining an inner surface thereof, which faces the interior space, and surrounded by the first part, and wherein the first part is configured to shield the second part and the interior space,
wherein the vias included in the first part are all ground vias and are spaced apart from each other by a first distance, and
wherein the vias included in the second part include signal vias and ground vias, the number of which is smaller than that of the signal vias, and are spaced apart from each other by a second distance that is larger than or equal to the first distance.

2. The electronic device of claim 1, wherein the first part includes a first via, a second via spaced apart from the first via in an extension direction of the interposer, and a first pad connected to the first via and the second via, and
wherein when viewed in the first direction, the first pad includes a first area covering an end of the first via, a second area covering an end of the second via, and a third area connecting the first area and the second area.

3. The electronic device of claim 2, wherein the first pads are formed on a first surface and a second surface of the interposer, respectively, to be mounted on the first board and the second board.

4. The electronic device of claim 2, wherein the first part further includes a third via located between the first via and the second via and connected to the third area, and
wherein when viewed in the first direction, the third via at least partially overlaps the third area.

5. The electronic device of claim 2, wherein the first area has a substantially circular or arc-shaped periphery, and has an area that is larger than a size of a first via hole of the first via, and
wherein the second area has a substantially circular or arc-shaped periphery, and has an area that is larger than a size of a second via hole of the second via.

6. The electronic device of claim 4, wherein a width of the third area is smaller than a maximum width of the first area or the second area, and
wherein the width is defined as a distance measured in a direction that is perpendicular to the extension direction of the interposer.

7. The electronic device of claim 4, wherein the first part further includes a fourth via spaced apart from the second via, and a second pad connected to the fourth via,
wherein an insulation area of a cover layer is formed between the second pad and the second area of the first pad, and
wherein the fourth via and the second via are electrically connected to each other through a conductive pattern disposed under the insulation area.

8. The electronic device of claim 7, wherein the first part further includes a fifth via located between the fourth via and the second via and at least partially contacting the conductive pattern, and
wherein when the interposer is viewed in the first direction, the fifth via is covered by the insulation area.

9. The electronic device of claim 8, wherein the first board or the second board includes a first mounting area facing the first pad and the second pad of the interposer, and a second mounting area facing the insulation area of the interposer,
wherein the first mounting area is a ground area, and
wherein the second mounting area includes a pattern, through which a signal that is not a ground signal flows.

10. The electronic device of claim 4, wherein the third via includes two or more third vias disposed in a widthwise direction that is perpendicular to the extension direction of the interposer.

11. The electronic device of claim 4, wherein the third via is formed longer in a widthwise direction that is perpendicular to the extension direction than in the extension direction, and
wherein a third via hole of the third via has a form, in which two via holes partially overlap each other.

12. The electronic device of claim 8, wherein the fifth via is formed longer in a widthwise direction that is perpendicular to the extension direction than in the extension direction, and
wherein a fifth via hole of the fifth via has a form, in which two via holes partially overlap each other.

13. The electronic device of claim 1, wherein the first distance is 0.2 mm or less, and the second distance is 0.5 mm to 0.8 mm.

14. The electronic device of claim 1, wherein when the interposer is viewed in the first direction, an area occupied by the vias included in the first part is smaller than an area occupied by the vias included in the second part.

15. The electronic device of claim 1 or 14, wherein the number of the vias included in the first part is smaller than the number of the vias included in the second part.
